# EUROPEAN PATENT APPLICATION

(11) **EP 4 358 323 A1**
(43) Date of publication of application: **24.04.2024**
(21) Application number: 22824885.2
(22) Date of filing: 08.06.2022
(51) Int. Cl.: H01S 5/10

(54) **SEMICONDUCTOR LASER BODY, SEMICONDUCTOR LASER ELEMENT, SEMICONDUCTOR LASER SUBSTRATE, ELECTRONIC APPARATUS, AND METHOD AND DEVICE FOR MANUFACTURING SEMICONDUCTOR LASER DEVICE**

(30) Priority: 17.06.2021 JP 2021100954
(71) Applicant: Kyocera Corporation, Kyoto-shi Kyoto 612-8501 (JP)
(72) Inventor: MURAKAWA, Kentaro, Kyoto-shi, Kyoto 612-8501 (JP); KAMIKAWA, Takeshi, Kyoto-shi, Kyoto 612-8501 (JP); KAWAGUCHI, Yoshinobu, Kyoto-shi, Kyoto 612-8501 (JP)
(74) Representative: Viering, Jentschura & Partner mbB Patent- und Rechtsanwälte
(86) International application number: PCT/JP2022/023089
(87) International publication number: WO 2022/264893

(57) **Abstract**

A semiconductor laser body includes a base semiconductor part and a compound semiconductor part positioned on the base semiconductor part and containing a GaN-based semiconductor. The base semiconductor part includes a first portion and a second portion having a lower density of threading dislocation extending in a thickness direction than the first portion, the compound semiconductor part includes an optical resonator including a pair of resonant end surfaces, at least one of the pair of resonant end surfaces is an m-plane or a c-plane of the compound semiconductor part, and a resonant length, which is a distance between the pair of resonant end surfaces, is equal to or less than 200 [µm].

## Description

### TECHNICAL FIELD

The present disclosure relates to a semiconductor laser and the like.

### BACKGROUND OF INVENTION

For example, Patent Document 1 discloses a semiconductor laser chip including an optical resonator.

### CITATION LIST

### PATENT LITERATURE

Patent Document 1: JP 2005-353702 A

### SUMMARY

A semiconductor laser body according to the present disclosure includes a base semiconductor part; and a compound semiconductor part positioned on the base semiconductor part and containing a GaN-based semiconductor. In the semiconductor laser body, the base semiconductor part comprises a first portion and a second portion having a lower density of threading dislocation extending in a thickness direction than the first portion, the compound semiconductor part comprises an optical resonator comprising a pair of resonant end surfaces, at least one of the pair of resonant end surfaces is an m-plane or a c-plane of the compound semiconductor part, and a resonant length, which is a distance between the pair of resonant end surfaces, is equal to or less than 200 [µm].

### BRIEF DESCRIPTION OF THE DRAWINGS

FIG. 1 is a perspective view illustrating a configuration of a semiconductor laser body according to the present embodiment.
FIG. 2 is a perspective view illustrating a configuration of an optical resonator.
FIG. 3 is a plan view illustrating a configuration of a compound semiconductor part.
FIG. 4 is a plan view illustrating a configuration of a compound semiconductor part.
FIG. 5 is a perspective view illustrating another configuration of the semiconductor laser body according to the present embodiment.
FIG. 6 is a schematic diagram illustrating a configuration of a semiconductor laser element according to the present embodiment.
FIG. 7 is a flowchart showing an example of a manufacturing method of a semiconductor laser device according to the present embodiment.
FIG. 8 is a block diagram illustrating an example of a manufacturing apparatus of the semiconductor laser body according to the present embodiment.
FIG. 9 is a perspective view illustrating a configuration of a semiconductor laser body according to Example 1.
FIG. 10 is a plan view illustrating a configuration of a device layer.
FIG. 11 is a cross-sectional view illustrating a configuration of the semiconductor laser body according to Example 1.
FIG. 12 is a cross-sectional view illustrating a configuration of a semiconductor laser element according to Example 1.
FIG. 13 is a perspective view illustrating a configuration of the semiconductor laser element according to Example 1.
FIG. 14 is a cross-sectional view illustrating another configuration of the semiconductor laser element according to Example 1.
FIG. 15 is a cross-sectional view illustrating another configuration of the semiconductor laser element according to Example 1.
FIG. 16 is a cross-sectional view illustrating another configuration of the semiconductor laser element according to Example 1.
FIG. 17 is a perspective view illustrating a configuration of a semiconductor laser substrate (semiconductor laser array) according to Example 1.
FIG. 18 is a perspective view illustrating another configuration of the semiconductor laser substrate according to Example 1.
FIG. 19 is a flowchart showing an example of a manufacturing method of a semiconductor laser device according to Example 1.
FIG. 20 is a schematic cross-sectional view illustrating a manufacturing method of the semiconductor laser device in FIG. 19.
FIG. 21 is a schematic cross-sectional view illustrating another example of the manufacturing method of the semiconductor laser device according to Example 1.
FIG. 22 is a schematic cross-sectional view illustrating another example of the manufacturing method of the semiconductor laser device according to Example 1.
FIG. 23 is a cross-sectional view illustrating an example of lateral growth of an ELO semiconductor layer in Example 1.
FIG. 24 is a flowchart showing another example of the manufacturing method of the semiconductor laser device according to Example 1.
FIG. 25 is a schematic diagram illustrating the manufacturing method of the semiconductor laser device in FIG. 24.
FIG. 26 is a flowchart showing another example of the manufacturing method of the semiconductor laser device according to Example 1.
FIG. 27 is a schematic diagram illustrating the manufacturing method of the semiconductor laser device in FIG. 26.
FIG. 28 is a flowchart showing another example of the manufacturing method of the semiconductor laser device according to Example 1.
FIG. 29 is a schematic diagram illustrating the manufacturing method of the semiconductor laser device in FIG. 28.
FIG. 30 is a perspective view illustrating a configuration of a semiconductor laser body according to Example 2.
FIG. 31 is a cross-sectional view illustrating a configuration of the semiconductor laser body according to Example 2.
FIG. 32 is a cross-sectional view illustrating a configuration of a semiconductor laser element according to Example 2.
FIG. 33 is a flowchart showing another example of a manufacturing method of a semiconductor laser device according to Example 2.
FIG. 34 is a schematic diagram illustrating the manufacturing method of the semiconductor laser device in FIG. 33.
FIG. 35 is a perspective view illustrating a configuration of the semiconductor laser element according to Example 2.
FIG. 36 is a perspective view illustrating a configuration of a semiconductor laser module of Example 4.
FIG. 37 is a perspective view illustrating another configuration of the semiconductor laser module of Example 4.
FIG. 38 is a schematic diagram illustrating a configuration of an electronic apparatus according to Example 5.
FIG. 39 is a perspective view illustrating a configuration of a semiconductor laser body according to Example 6.

### DESCRIPTION OF EMBODIMENTS

### Semiconductor Laser Body

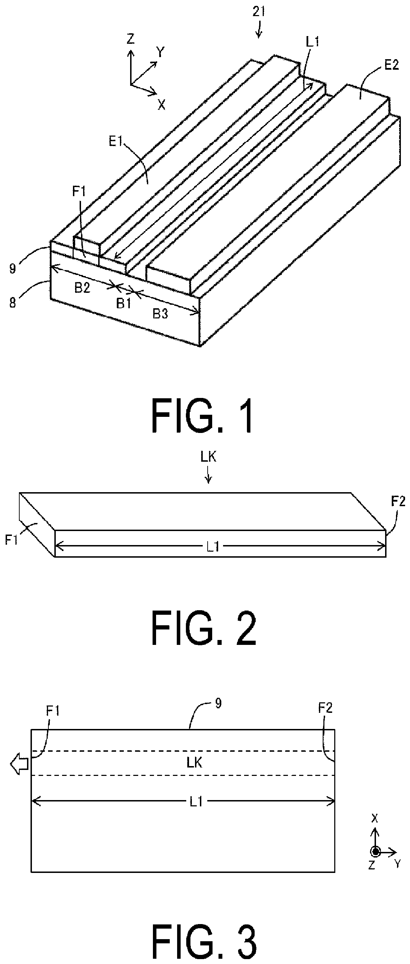

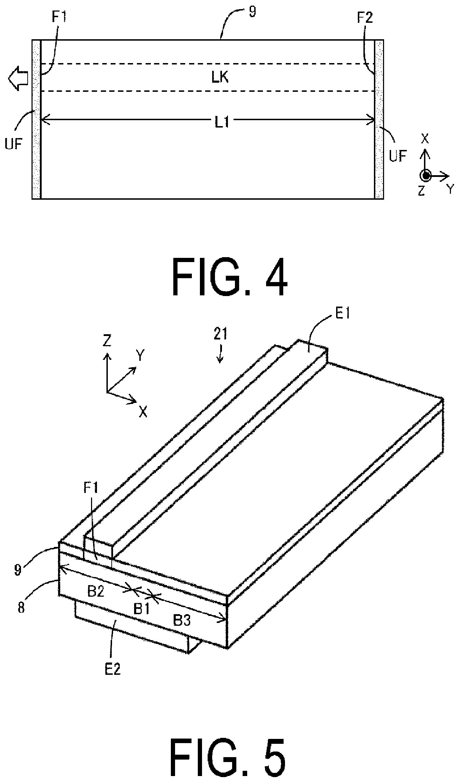

FIG. 1 is a perspective view illustrating the configuration of the semiconductor laser body according to the present embodiment. FIG. 2 is a perspective view illustrating the configuration of the optical resonator. FIGs. 3 and 4 are plan views illustrating the configuration of the compound semiconductor part. FIG. 5 is a perspective view illustrating another configuration of the semiconductor laser body according to the present embodiment.

As illustrated in FIGs. 1 to 4, a semiconductor laser body 21 according to the present embodiment includes a base semiconductor part 8 and a compound semiconductor part 9, which is positioned on the base semiconductor part 8 and contains a nitride semiconductor (e.g., a GaN-based semiconductor). The base semiconductor part 8 may be a base semiconductor layer, and the compound semiconductor part 9 may be a compound semiconductor layer. The base semiconductor part 8 includes a first portion B1 and a second portion B2 in which the density of threading dislocations (threading dislocation density) extending in the thickness direction (Z direction) is smaller than that in the first portion B1. The compound semiconductor part 9 includes an optical resonator LK including a pair of resonant end surfaces F1 and F2.

The semiconductor laser body 21 can have a configuration in which at least one of the pair of resonant end surfaces F1 and F2 is an m-plane or a c-plane of the compound semiconductor part 9 containing a nitride semiconductor and a resonant length (resonator length) L1 between the pair of resonant end surfaces (resonator end surfaces) F1 and F2 is equal to or less than 200 [µm]. Each of the pair of resonant end surfaces F1 and F2 may be the m-plane of the compound semiconductor part 9, or each of the pair of resonant end surfaces F1 and F2 may be the c-plane of the compound semiconductor part 9. The m-plane is a plane parallel to the (1-100) plane of the nitride semiconductor, and the c-plane is a plane parallel to the (0001) plane of the nitride semiconductor.

The semiconductor laser body 21 can have a configuration in which at least one of the pair of resonant end surfaces F1 and F2 is included in a cleavage plane of the compound semiconductor part 9 and the resonant length L1 is equal to or less than 200 [µm]. Each of the pair of resonant end surfaces F1 and F2 may be included in the cleavage plane of the compound semiconductor part 9.

The semiconductor laser body 21 can have a configuration in which the optical reflectance of at least one of the pair of resonant end surfaces F1 and F2 is equal to or greater than 98% and the resonant length L1 is equal to or less than 200 [µm]. The optical reflectance of each of the pair of resonant end surfaces F1 and F2 may be equal to or greater than 98%, and as illustrated in FIG. 3B, a reflection boundary film UF (e.g., a dielectric film) covering the resonant end surfaces F1 and F2 may be provided.

In the semiconductor laser body 21, the optical reflectance of at least one of the resonant end surfaces F1 and F2 is high and the reflection loss is small, and thus stable laser oscillation becomes possible even at a short resonant length of equal to or less than 200 µm at which the optical gain decreases.

The base semiconductor part 8 and the compound semiconductor part 9 contain, for example, a nitride semiconductor. The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be a doped type (e.g., an n-type including a donor) or a non-doped type.

The base semiconductor part 8 containing a nitride semiconductor can be formed by an epitaxial lateral overgrowth (ELO) method. Hereinafter, the semiconductor layer formed by the ELO method may be referred to as an ELO semiconductor layer. In the ELO method, for example, the base semiconductor part 8 is laterally grown on a template substrate including a mask portion (described later). In this manner, a low defect portion (second portion B2) having a low threading dislocation density can be formed on the mask portion. Since the dislocation (defect) taken over by the compound semiconductor part 9 (e.g., a GaN-based semiconductor layer) on the second portion B2 decreases, the resonant end surfaces F1 and F2 being excellent in planarity and verticality to the c-plane and having high optical reflectance can be formed in the compound semiconductor part 9.

The semiconductor laser body 21 may be provided with a first electrode E1 and a second electrode E2 for supplying the optical resonator LK with current. The first electrode E1 can be disposed so as to overlap the optical resonator LK in plan view viewed in the thickness direction of the base semiconductor part 8. Note that "two members overlap" means that at least a part of one member overlaps the other member in plan view (including perspective plan view) viewed in the thickness direction of each member, and these members may be in contact with each other or need not be in contact with each other.

In FIG. 1, the first and electrodes E1 and E2 are provided on the same side with respect to the base semiconductor part 8, and the first and second electrodes E1 and E2 do not overlap in plan view, but this configuration (single-sided electrode) is not necessarily employed. As illustrated in FIG. 5, the first and electrodes E1 and E2 may be provided on different sides with respect to the base semiconductor part 8, and the first and second electrodes E1 and E2 may overlap each other in plan view (double-sided electrode).

### Semiconductor Laser Device

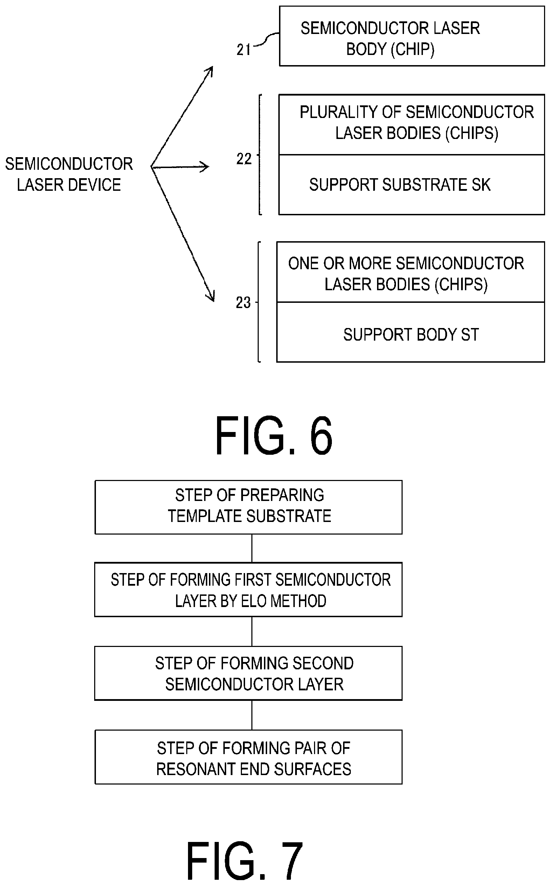

FIG. 6 is a schematic diagram illustrating the configuration of the semiconductor laser element according to the present embodiment. A semiconductor laser element 23 according to the present embodiment includes one or more semiconductor laser bodies 21 and a support body ST on which the one or more semiconductor laser bodies 21 are placed. A semiconductor laser substrate 22 according to the present embodiment includes a plurality of the semiconductor laser bodies 21 and a support substrate SK on which the plurality of semiconductor laser bodies 21 are placed. Hereinafter, the semiconductor laser body 21, the semiconductor laser element 22, the semiconductor laser substrate (semiconductor laser array) 23, and a semiconductor laser module described later may be collectively referred to as a semiconductor laser device.

### Manufacture of Semiconductor Laser Device

FIG. 7 is a flowchart showing an example of the manufacturing method of the semiconductor laser device according to the present embodiment. In the manufacturing method of FIG. 7, after a step of preparing a template substrate (ELO growth substrate) 7, a step of forming a first semiconductor layer, which serves as a base of the base semiconductor part 8, using the ELO method is performed. Thereafter, a step of forming a second semiconductor layer, which serves as a base of the compound semiconductor part 9, and a step of forming the pair of resonant end surfaces F1 and F2 on the second semiconductor layer are performed.

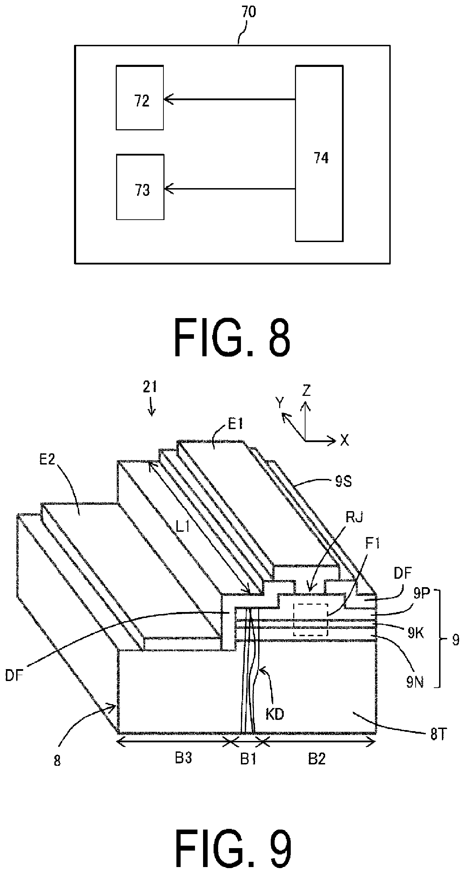

FIG. 8 is a block diagram illustrating an example of the manufacturing apparatus of the semiconductor laser body according to the present embodiment. A manufacturing apparatus 70 of the semiconductor laser body in FIG. 8 includes a semiconductor layer former 72 that forms the first semiconductor layer and the second semiconductor layer on the template substrate 7, a semiconductor layer processor 73 that forms the pair of resonant end surfaces on the second semiconductor layer, and a controller 74 that controls the semiconductor layer former 72 and the semiconductor layer processor 73.

The semiconductor layer former 72 may include a metal organic chemical vapor deposition (MOCVD) device, and the controller 74 may include a processor and a memory. The controller 74 may be configured to control the semiconductor layer former 72 and the semiconductor layer processor 73, for example, by executing a program stored in a built-in memory, a communicable communication device, or an accessible network. The program and a recording medium storing the program are also included in the present embodiment.

### Example 1

### (Configuration)

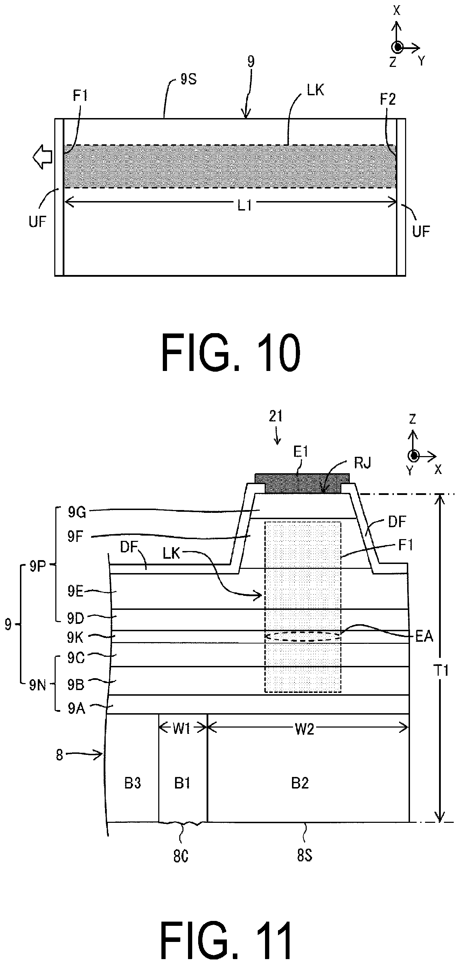

FIG. 9 is a perspective view illustrating the configuration of the semiconductor laser body according to Example 1. FIG. 10 is a plan view illustrating the configuration of a device layer. FIG. 11 is a cross-sectional view illustrating the configuration of the semiconductor laser body according to Example 1. As illustrated in FIGs. 9 to 11, the semiconductor laser body 21 according to Example 1 includes the base semiconductor part 8, the compound semiconductor part 9 positioned on the base semiconductor part 8, the first electrode E1 that is an anode, and the second electrode E2 that is a cathode. The semiconductor laser body 21 can also be referred to as a semiconductor laser chip.

The base semiconductor part 8 and the compound semiconductor part 9 are nitride semiconductor layers (e.g., GaN-based semiconductor layers), and the base semiconductor part 8 is an n-type semiconductor layer including a donor. In FIG. 9 and the like, a <11-20> direction of the base semiconductor part 8 is an X direction, a <1-100> direction is a Y direction, and a <0001> direction is a Z direction (thickness direction).

The base semiconductor part 8 is a self-supported layer with no support material. The base semiconductor part 8 includes the first portion B 1 including threading dislocation KD extending in the Z direction, and the second portion B2 and a third portion B3 having a threading dislocation density lower than that of the first portion B1. The second portion B2, the first portion B, and the third portion B3 are arranged in this order in the X direction, and the first portion B 1 is positioned between the second portion B2 and the third portion B3. The first portion B1 is a portion positioned above an opening portion of a mask layer 6 when the base semiconductor part 8 is formed by the ELO method (described later). The first portion B1 may be a dislocation inheritance portion. The threading dislocation density of the second portion B2 and the third portion B3 is equal to or lower than 1/5 of the threading dislocation density of the first portion B1 (e.g., 5 × 10⁶/cm² or less). Since the base semiconductor part 8 is a self-supported layer, in the semiconductor laser body 21, the back surface (e.g., -c-plane) of the base semiconductor part 8 may be in an exposed state.

The compound semiconductor part 9 is formed by forming, in this order, an n-type semiconductor layer 9N including a donor, an active layer 9K, and a p-type semiconductor layer 9P including an acceptor. The n-type semiconductor layer 9N is formed by forming a first contact layer 9A, a first clad layer 9B, and a first light guide layer 9C in this order. The p-type semiconductor layer 9P may be formed by forming a second light guide layer 9D, an electron blocking layer 9E, a second clad layer 9F, and a second contact layer 9G in this order. The first electrode E1 (anode) may be formed on the second contact layer 9G.

The second electrode E2 may be provided on the same side as the first electrode E1 with respect to the base semiconductor part 8. The second electrode E2 is in contact with the base semiconductor part 8, and the first and second electrodes E1 and E2 do not overlap in plan view. Specifically, the base semiconductor part 8 may have a larger width in the X direction than the compound semiconductor part 9, and the second electrode E2 may be formed on an exposed portion of the base semiconductor part 8 where the compound semiconductor part 9 is not formed. For example, a part of the compound semiconductor part 9 may be dug by etching or the like to expose the base semiconductor part 8, and the second electrode E2 may be provided in contact with the base semiconductor part 8. A part of the compound semiconductor part 9 may be dug by etching or the like to expose the first contact layer 9A in the compound semiconductor part 9, and the second electrode E2 may be provided in contact with the first contact layer 9A.

The compound semiconductor part 9 includes the optical resonator LK including the pair of resonant end surfaces F1 and F2, and the resonant length L1, which is a distance between the pair of resonant end surfaces F1 and F2, is equal to or less than 200 [µm]. The resonant length L1 may be equal to or greater than 10 [µm] and equal to or less than 200 [µm]. Each of the resonant end surfaces F1 and F2 is the m-plane of the compound semiconductor part 9, and may be included in the cleavage plane of the compound semiconductor part 9. That is, each of the resonant end surfaces F1 and F2 can be formed by performing m-plane cleavage of the compound semiconductor part 9, which is a nitride semiconductor layer (e.g., a GaN-based semiconductor layer). At least one of the base semiconductor part 8 and the compound semiconductor part 9 may have a scribe trace for cleavage (trace of cleavage starting point formation).

Each of the resonant end surfaces F1 and F2 is covered with the reflection boundary film UF (e.g., a dielectric film), and the optical reflectance of the resonant end surface F1 on a light emission face side is equal to or greater than 98%. The optical reflectance of the resonant end surface F1 may be equal to or greater than 98.00% and equal to or less than 99.99%. The optical reflectance of the resonant end surface F2 on a light reflection face side is higher than the optical reflectance of the resonant end surface F1. Although not illustrated in FIG. 9, the reflection boundary film UF can be formed on the base semiconductor part 8 and the entire cleavage plane (m-plane) of the compound semiconductor part 9.

The first electrode E1 overlaps the optical resonator LK in plan view and overlaps the second portion B2 of the base semiconductor part 8. The first electrode E1 has a shape in which the direction of the resonant length (Y direction) is a long direction, and the length of the first electrode E1 in the Y direction is smaller than the resonant length L1. Therefore, the first electrode E1 does not interfere with the cleavage of the compound semiconductor part 9 when the cleavage of the compound semiconductor part 9 is performed.

The optical resonator LK includes a portion (a portion overlapping the first electrode E1 in plan view) of each of the n-type semiconductor layer 9N, the active layer 9K, and the p-type semiconductor layer 9P. For example, the optical resonator LK includes a portion (a portion overlapping the first electrode E1 in plan view) of each of the first clad layer 9B, the first light guide layer 9C, the active layer 9K, the second light guide layer 9D, the electron blocking layer 9E, and the second clad layer 9F.

In the optical resonator LK, the refractive index (light refractive index) is lower in the order of the active layer 9K, the first light guide layer 9C, and the first clad layer 9B, and the refractive index is lower in the order of the active layer 9K, the second light guide layer 9D, and the second clad layer 9F. Therefore, light generated by combination of, in the active layer 9K, holes supplied from the first electrode E1 and electrons supplied from the second electrode E2 is confined in the optical resonator LK (in particular, the active layer 9K), and laser oscillation occurs due to stimulated emission and a feedback action in the active layer 9K. The laser light generated by the laser oscillation is emitted from a light emission region EA of the resonant end surface F1 on the emission face side.

Since the resonant end surfaces F1 and F2 are formed by m-plane cleavage, the resonant end surfaces F1 and F2 are excellent in planarity and verticality to the c-plane (parallelism of the resonant end surfaces F1 and F2) and have a high optical reflectance. Therefore, the reflection loss can be reduced, and stable laser oscillation becomes possible even at a short resonant length of equal to or less than 200 µm at which the optical gain decreases. Since the resonant end surfaces F1 and F2 are formed above the second portion B2, which is a low dislocation portion, planarity of the cleavage plane is excellent, and a high optical reflectance is achieved.

The compound semiconductor part 9 may include a ridge portion RJ overlapping the first electrode E1 in plan view, and the ridge portion RJ may include the second clad layer 9F and the second contact layer 9G. The ridge portion RJ has a shape in which the Y direction is a long direction, and an insulating film DF may be provided so as to cover a side surface of the ridge portion RJ. Both ends in the X direction of the first electrode E1 may overlap the insulating film DF in plan view. The refractive index of the insulating film DF is lower than the refractive indices of the second light guide layer 9D and the second clad layer 9F. By providing the ridge portion RJ and the insulating film DF, a current path between the first electrode E1 and the base semiconductor part 8 is narrowed on the anode side, and light can be efficiently emitted in the resonator LK.

The ridge portion RJ overlaps the second portion B2 (low dislocation portion) of the base semiconductor part 8 in plan view and does not overlap the first portion B1. In this manner, the current path from the first electrode E1 to the second electrode E2 via the compound semiconductor part 9 and the base semiconductor part 8 is formed in a portion overlapping the second portion B2 in plan view (a portion having few threading dislocations), and the light emission efficiency in the active layer 9K is enhanced. This is because the threading dislocations act as a non-light-emission recombination center. Since the second electrode E2 overlaps the third portion B3 (low dislocation portion) of the base semiconductor part 8 in plan view, the efficiency of electron injection from the second electrode E2 to the base semiconductor part 8 is enhanced.

In Example 1, a sum T1 of the thickness of the base semiconductor part 8 and the thickness of the compound semiconductor part 9 can be equal to or greater than 5 [µm] and equal to or less than 50 [µm]. A too large sum T1 of the thicknesses makes it difficult to perform cleave such that the resonant length becomes equal to or less than 200 µm. The ratio of the resonant length L1 to the thickness of the second portion B2 of the base semiconductor part 8 can be 1 to 20. When a direction orthogonal to the direction of the resonant length L1 is the first direction (X direction) and the size in the X direction of the second portion B2 is a width W2 of the second portion B2, the ratio of the resonant length L 1 to the width W2 of the second portion B2 can be 1 to 10. When the size in the X direction of the first portion B1 is a width W1 of the first portion B1, the ratio of the resonant length L1 to the width W1 of the first portion can be 1 to 200.

The base semiconductor part 8 may include a base end surface 8T (cleavage plane) that is flush with the resonant end surface F1, and the density of dislocation (dislocation where cathode luminescence (CL) is measured in the cleavage plane, mainly basal plane dislocation) in the base end surface 8T may be equal to or greater than the threading dislocation density of the second portion B2. The surface roughness of at least one of the pair of resonant end surfaces F1 and F2 (e.g., the resonant end surface F2 on the reflection face side) can be smaller than the surface roughness of a side surface 9S (see FIG. 10), which is the a-plane of the compound semiconductor part 9. The a-plane is a plane parallel to the (11-20) plane of the nitride semiconductor layer.

In Example 1, for example, power of equal to or greater than 1 [mW] and equal to or less than 200 [mW] is supplied between the first and second electrodes E1 and E2 of the semiconductor laser body, and the semiconductor laser body can achieve high efficiency and low output because of a short resonant length of equal to or less than 200 µm.

The lower surface (back surface) of the base semiconductor part 8 may include a first region 8C and a second region 8S. The first region 8C may be larger in surface roughness than the second region 8S. At least one of a protruding portion and a recessed portion may be formed in the first region 8C. For example, a plurality of raised portions having a random shape and a plurality of recesses having a random shape may be formed. The first region 8C may be a region corresponding to the first portion B1 (e.g., a central region), and the second region 8S may be a region corresponding to the second portion B2 (e.g., a side region between the central region and an edge). The first region 8C may be formed so as not to overlap the ridge portion RJ in plan view. The first region 8C may enhance heat dissipation. A dielectric film of the same material as that of a reflector film UF may be formed in at least a part of the first region 8C.

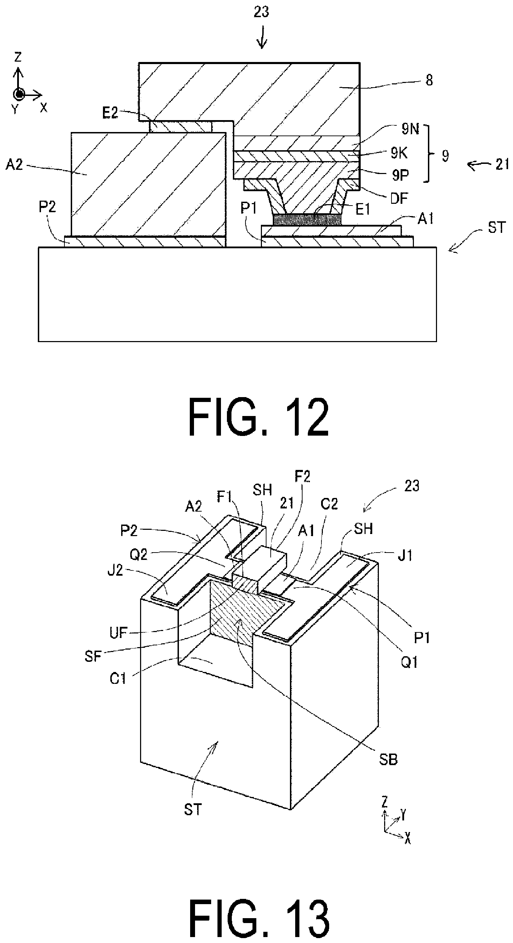

FIG. 12 is a cross-sectional view illustrating the configuration of the semiconductor laser element according to Example 1. The semiconductor laser element 23 includes the semiconductor laser body 21 including the base semiconductor part 8 and the compound semiconductor part 9, and the support body ST holding the semiconductor laser body 21. Examples of the material of the support body ST include Si, SiC, and AlN. The support body ST is disposed such that the compound semiconductor part 9 and the first and second electrodes E1 and E2 are positioned between the support body ST and the base semiconductor part 8.

The support body ST includes a conductive first pad portion P1 and a conductive second pad portion P2, the first electrode E1 is connected to the first pad portion P1 via a first bonding portion A1, and the second electrode E2 is connected to the second pad portion P2 via a second bonding portion A2. The second bonding portion A2 is larger in thickness than the first bonding portion A1, and the difference in thickness between the first and second bonding portions A1 and A2 is equal to or greater than the thickness of the compound semiconductor part 9. This enables the first and second electrodes E1 and E2 to be connected to the first and second pad portions P1 and P2 positioned on the same plane. That is, the semiconductor laser element 23 functions as a chip on submount (COS).

FIG. 13 is a perspective view illustrating the configuration of the semiconductor laser element according to Example 1. As illustrated in FIG. 13, the semiconductor laser element 23 includes the semiconductor laser body 21 and the support body ST. The support body ST includes two wide portions SH having a width larger than the resonant length of the semiconductor laser body 21, and a placement portion SB positioned between the two wide portions SH and having a width smaller than the resonant length. The semiconductor laser body 21 is positioned above the placement portion SB such that the width direction (Y direction) of the placement portion SB coincides with the direction of the resonant length, and the pair of resonant end surfaces F1 and F2 protrude from the placement portion SB in plan view. In other words, the placement portion SB is formed between two notch portions C1 and C2 facing each other in the direction (Y direction) defining the resonant length, the resonant end surface F1 is positioned above the notch portion C1, and the resonant end surface F2 is positioned above the notch portion C2. The shapes of the notch portions C1 and C2 can be, for example, rectangular in plan view viewed in the Z direction. By providing the support body ST with the notch portions C1 and C2 and disposing the resonant end surface F1 such that it protrudes from the placement portion SB, a problem that laser light emitted from the resonant end surface F1 is blocked by the light-blocking support body ST is eliminated.

The support body ST may include the first pad portion P1 and the second pad portion P2 having T shapes. The first pad portion P1 includes a mounting portion J1 positioned on the wide portion SH and having a length in the Y direction larger than the resonant length L1, and a contact portion Q1 positioned on the placement portion SB and having a length in the Y direction smaller than the resonant length L1. The second pad portion P2 includes a mounting portion J2 positioned on the wide portion SH and having a length in the Y direction larger than the resonant length L1, and a contact portion Q2 positioned on the placement portion SB and having a length in the Y direction smaller than the resonant length L1. The contact portions Q1 and Q2 may be arranged in the X direction on the upper surface of the placement portion SB, the first bonding portion A1 may be formed on the contact portion Q1, and the second bonding portion A2 may be formed on the contact portion Q2. The first bonding portion A1 is contact with the first electrode E1 of the semiconductor laser body 21, and the second bonding portion A2 is in contact with the second electrode E2 of the semiconductor laser body 21. Solder such as AuSi or AuSn can be used as the material of the first and second bonding portions A1 and A2.

The resonant end surfaces F1 and F2 of the semiconductor laser body 21 are covered with the reflection boundary film UF, and a dielectric film SF made of the same material as the reflector film UF may be formed on a surface (e.g., the side surface of the placement portion SB) parallel to the resonant end surfaces F1 and F2 among the side surfaces of the support body ST.

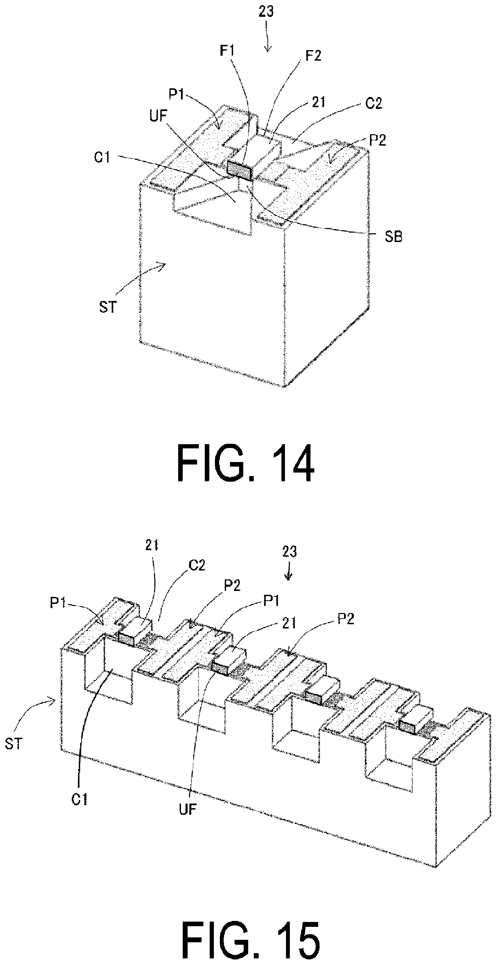

FIG. 14 is a cross-sectional view illustrating another configuration of the semiconductor laser element according to Example 1. In FIG. 13, the notch portions C1 and C2 are rectangular in plan view viewed in the Z direction, but the notch portions C1 and C2 are not limited to this. As illustrated in FIG. 14, the notch portions C1 and C2 may have a trapezoidal shape with the placement portion SB side as a short side in plan view viewed in the Z direction.

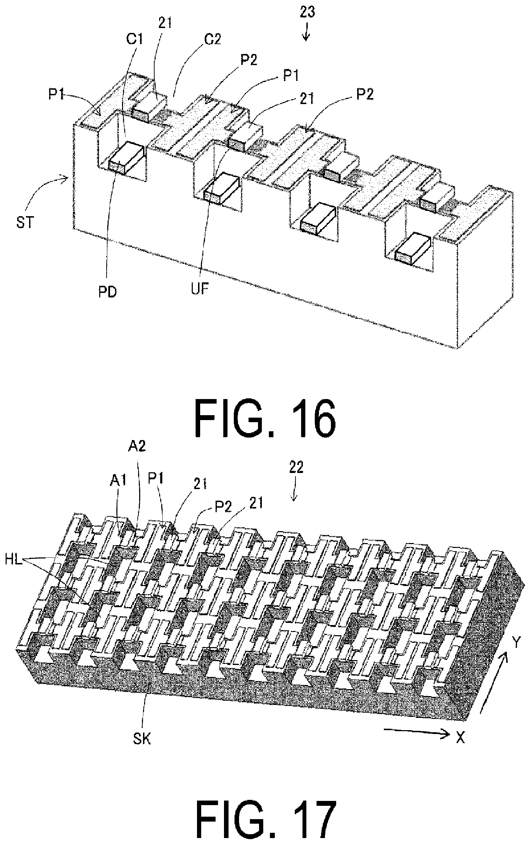

FIGs. 15 and 16 are cross-sectional views illustrating other configurations of the semiconductor laser element according to Example 1. In the semiconductor laser element 23 of FIG. 15, the plurality of semiconductor laser bodies 21 may be arranged on the support body ST in a direction (X direction) orthogonal to the direction defining the resonant length such that the directions of the resonant length are aligned, and the first and second pad portions P1 and P2 may be provided for a corresponding one of the semiconductor laser bodies 21. As illustrated in FIG. 16, the notch portion C1 of the support body ST may be provided with a sensor device (electronic device) such as a photodiode PD. In that case, the light from the semiconductor laser body 21 can be detected by the photodiode PD, and the emission intensity of the semiconductor laser body 21 can be feedback-controlled.

FIG. 17 is a perspective view illustrating the configuration of a semiconductor laser substrate (semiconductor laser array) according to Example 1. The semiconductor laser substrate 22 includes the support substrate SK and the plurality of semiconductor laser bodies 21. In the semiconductor laser substrate 22, the plurality of semiconductor laser bodies 21 may be arranged on the support substrate SK in a matrix in a direction (Y direction) defining the resonant length and a direction (X direction) orthogonal to the Y direction such that the directions of the resonant length are aligned. The first and second pad portions P1 and P2 and the first and second bonding portions A1 and A2 may be provided for a corresponding one of the semiconductor laser bodies 21.

The support substrate SK can be formed, for example, by providing a Si substrate, a SiC substrate, or the like with a plurality of recessed portions HL (rectangular in plan view) in a matrix and providing non-recessed portions with a plurality of the first pad portions P 1, a plurality of the second pad portions P2, a plurality of the first bonding portions A1, and a plurality of the second bonding portions A2.

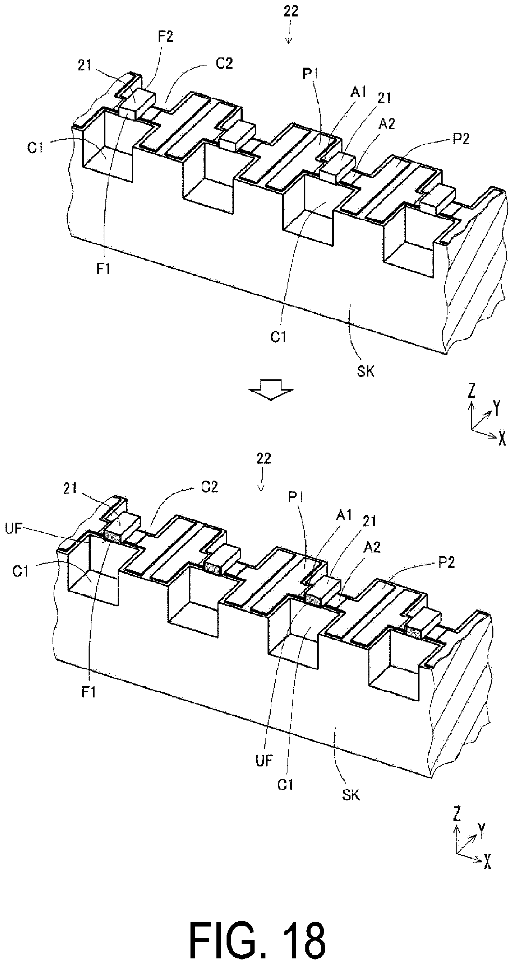

FIG. 18 is a perspective view illustrating another configuration of the semiconductor laser substrate according to Example 1. A two-dimensional arrangement semiconductor laser substrate in which a plurality of semiconductor laser bodies are arranged in a matrix as illustrated in FIG. 16 can be laterally divided (divided for each row extending in the X direction) to provide a one-dimensional arrangement (bar-shaped) semiconductor laser substrate as illustrated in FIG. 18. The one-dimensional arrangement facilitates formation of the reflection boundary film UF on the pair of resonant end surfaces F1 and F2.

### Manufacturing Method

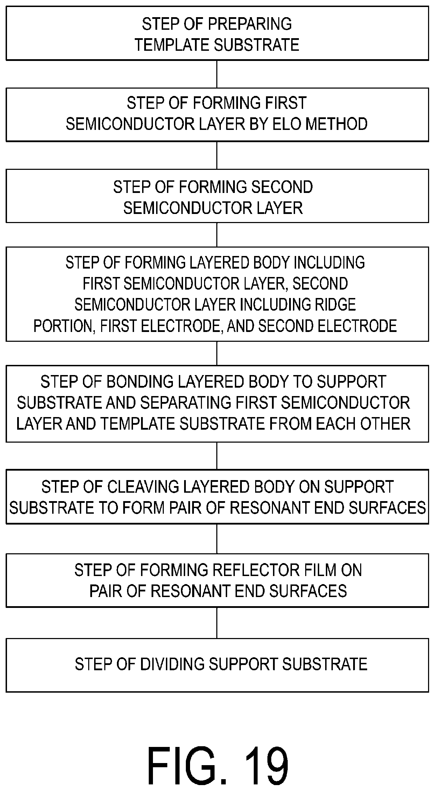

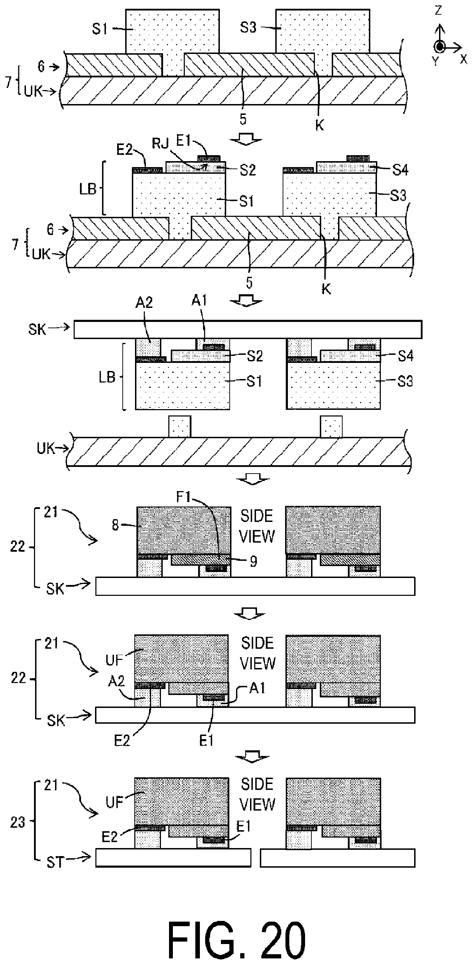

FIG. 19 is a flowchart showing an example of the manufacturing method of the semiconductor laser device according to Example 1. FIG. 20 is a schematic cross-sectional view illustrating the manufacturing method of the semiconductor laser device in FIG. 19. The manufacturing method illustrated in FIGs. 19 and 20 includes a step of preparing the template substrate 7 including a base substrate UK and the mask layer 6, a step (described later) of forming a band-shaped (long shape, ridge shape) first semiconductor layer S1 (and a third semiconductor layer S3), which serves as a base of the base semiconductor part 8, by the ELO method, a step of forming a second semiconductor layer S2 (and a fourth semiconductor layer S4), which serves as a base of the compound semiconductor part 9, a step of forming a layered body LB including the first semiconductor layer S1, the second semiconductor layer S2 including a ridge portion, and the first electrode E1 and the second electrode E2, a step of bonding the layered body LB to the support substrate SK and separating the first semiconductor layer S1 and the template substrate 7 from each other, a step of performing cleavage of the layered body LB on the support substrate SK and forming (the optical resonator LK including) the pair of resonant end surfaces F 1 and F2, a step of forming the reflector film UF on each of the pair of resonant end surfaces F1 and F2, and a step of dividing the support substrate SK into a plurality of the support bodies ST.

After the formation of the layered body LB, the mask layer 6 is removed by etching, and the layered body LB is bonded to the support substrate SK in a state where the first and second bonding portions A1 and A2 (e.g., solder) of the support substrate SK are heated and melted. Due to this, a bonding portion (downward protruding portion) with the base substrate UK on the back surface of the first semiconductor layer S1 is broken, and the first semiconductor layer S1 is separated from the template substrate 7. Since the first semiconductor layer S1 and the base substrate UK were in the state of being bonded at an interface between the both, an interface adjacent portion of the first semiconductor layer S1 may be attached to the base substrate UK side as illustrated in FIG. 20 or may be attached to the first semiconductor layer S1 side after the first semiconductor layer S1 and the base substrate UK are separated from each other. The interface adjacent portion of the base substrate UK may remain on the base substrate UK side or may be attached to the first semiconductor layer S1 side.

Thereafter, cleavage of the layered body LB is performed (m-plane cleavage of the first and second semiconductor layers S1 and S2, which are nitride semiconductor layers) on the support substrate SK to form the pair of resonant end surfaces F1 and F2. Scribing (e.g., formation of a scribe groove serving as a cleavage starting point) may be performed on the layered body LB before cleavage. Due to this, the two-dimensional arrangement semiconductor laser substrate (see FIG. 17) is formed. Next, the two-dimensional arrangement semiconductor laser substrate is divided for each row to form the one-dimensional arrangement (rod-like) semiconductor laser substrate 22 (see FIG. 18). Next, the reflector film UF is formed on the resonant end surfaces F1 and F2 of the one-dimensional arrangement semiconductor laser substrate 22. Thereafter, the support substrate SK is divided into the plurality of support bodies ST, and one or more semiconductor laser bodies 21 are held by each of the support bodies ST, thereby forming a plurality of the semiconductor laser elements 23 of a junction-down type (see FIGs. 13 to 15). The reflector film UF (e.g., a dielectric film) may be formed not only on the base semiconductor part 8 and the cleavage plane (m-plane) of the compound semiconductor part 9 but also on a plane (including the side surface of the placement portion SB) parallel to the resonant end surfaces F1 and F2 among the side surfaces of the support body ST.

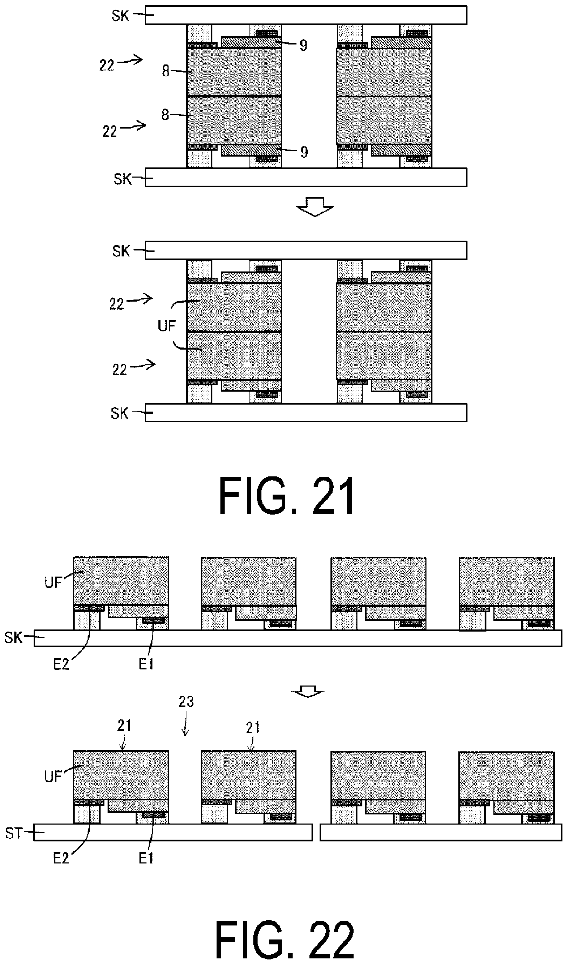

FIGs. 21 and 22 are schematic cross-sectional views illustrating other examples of the manufacturing method of the semiconductor laser device according to Example 1. As illustrated in FIG. 21, a plurality of the one-dimensional arrangement semiconductor laser substrates 22 (see FIG. 18) can be overlapped in the Z direction such that the back surfaces of the base semiconductor parts 8 face each other, and the reflector films UF can be simultaneously formed on the resonant end surfaces F1 and F2 of the semiconductor laser substrates 22. As illustrated in FIG. 22, when the support substrate SK is divided into the plurality of support bodies ST, the plurality of semiconductor laser bodies 21 are held by the respective support bodies ST, whereby the semiconductor laser bodies 21 illustrated in FIG. 15 can also be formed.

### (Base Semiconductor Part)

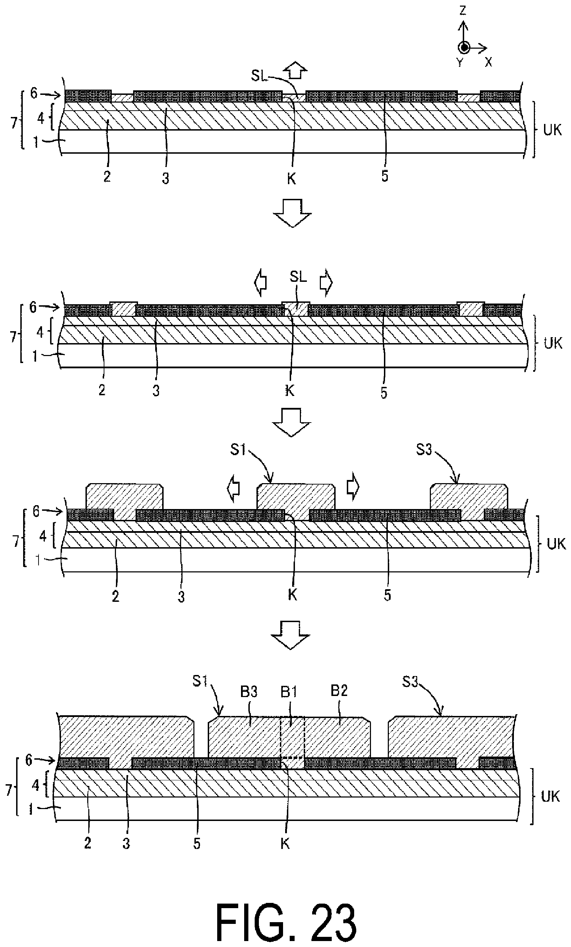

FIG. 23 is a cross-sectional view illustrating an example of lateral growth of the ELO semiconductor layer in Example 1. As illustrated in FIG. 23, the base substrate UK includes a main substrate 1 and a base layer 4 on the main substrate 1, and a seed layer 3 of the base layer 4 is exposed through an opening portion K of a mask portion 5. In the ELO method, first, an initial growth layer SL is formed on the seed layer 3, and then the first semiconductor layer S1 can be laterally grown from the initial growth layer SL. The initial growth layer SL is a starting point of the lateral growth of the first semiconductor layer S1 and is a part of the first portion B1 of the base semiconductor part 8. By appropriately controlling the ELO film formation conditions, control of causing the first semiconductor layer S1 to grow in the Z direction (c-axis direction) or in the X direction (a-axis direction) is possible.

Here, it is preferable that the film formation of the initial growth layer SL is stopped (i.e., at this timing, the ELO film formation condition is switched from a c-axis direction film formation condition to an a-axis direction film formation condition) immediately before the edge of the initial growth layer SL rides on the upper surface of the mask portion 5 (in a stage of being in contact with the side surface upper end of the mask portion 5) or immediately after the edge of the initial growth layer SL rides on the upper surface of the mask portion 5. In this manner, the lateral film formation is performed from the state in which the initial growth layer SL slightly protrudes from the mask portion 5; thus, the material is less likely to be consumed for the growth in the thickness direction of the first semiconductor layer S1, and the first semiconductor layer S1 can be grown laterally at a high speed. The initial growth layer SL may be formed to have a thickness of, for example, 2.0 µm or more and 3.0 µm or less.

In Example 1, the first semiconductor layer S1, which serves as a base of the base semiconductor part 8, was an n-type GaN layer, and an ELO film of Si-doped GaN (gallium nitride) was formed on the template substrate 7 using an MOCVD device. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount). Note that the lateral growth of the first and third semiconductor layers S1 and S3 was stopped before the first and third semiconductor layers S1 and S3 that laterally grow from both sides on the mask portion 5 met.

The width of the mask portion 5 was 50 µm, the width of the opening portion K was 5 µm, the lateral width of the first semiconductor layer S1 was 53 µm, the widths (sizes in the X direction) of low defect portions B2 and B3 were 24 µm, and the layer thickness of the first semiconductor layer S1 was 5 µm. The aspect ratio of the first semiconductor layer S1 was 53 µm/5 µm = 10.6, and a high aspect ratio was achieved.

As the main substrate 1 in FIG. 23, a heterogeneous substrate having a lattice constant different from that of the nitride semiconductor can be used. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate.

As the base layer 4 in FIG. 23, a buffer layer 2 and the seed layer 3 can be provided in order from the main substrate 1 side. For example, when a silicon substrate is used as the main substrate 1 and a GaN-based semiconductor is used as the seed layer 3, the both (the main substrate and the seed layer) are melted each other, and therefore, for example, by providing the buffer layer 2 including at least one of an AlN layer and a silicon carbide (SiC) layer, melting is reduced. The buffer layer 2 may have at least one of an effect of enhancing the crystallinity of the seed layer 3 and an effect of alleviating the internal stress of the first semiconductor layer S1. When the main substrate 1 that is not melted with the seed layer 3 is used, a configuration in which the buffer layer 2 is not provided is also possible. Note that the configuration in which the seed layer 3 overlaps the entire mask portion 5 as illustrated in FIG. 23 is not necessarily employed. Since the seed layer 3 is exposed through the opening portion K, the seed layer 3 may be locally formed so as not to overlap a part or the entirety of the mask portion 5.

The opening portion K of the mask layer 6 has a function of a growth start hole for exposing the seed layer 3 and causing the growth of the first semiconductor layer S1 to start, and the mask portion 5 of the mask layer 6 has a function of a selective growth mask for allowing the first semiconductor layer S1 to laterally grow. The mask layer 6 may be a mask pattern including the mask portion 5 and the opening portion K.

As the mask layer 6, for example, a single-layer film including any one of a silicon oxide film (SiOx), a titanium nitride film (TiN or the like), a silicon nitride film (SiNx), a silicon oxynitride film (SiON), and a metal film having a high melting point (e.g., 1000 °C or higher), or a layered film including at least two of these films can be used.

For example, a silicon oxide film having a thickness of from about 100 nm to about 4 µm (preferably from about 150 nm to about 2 µm) is formed on the entire surface of the base layer 4 by sputtering, and a resist is applied onto the entire surface of the silicon oxide film. Thereafter, the resist is patterned by photolithography to form the resist including a plurality of stripe-shaped opening portions. Thereafter, a part of the silicon oxide film is removed with wet etchant such as hydrofluoric acid (HF) or buffered hydrofluoric acid (BHF) to form a plurality of the opening portions K, and the resist is removed by organic cleaning to form the mask layer 6.

The opening portions K have a long shape (slit shape) and are arrayed at regular intervals in the a-axis direction (X direction) of the first semiconductor layer S1. The width of the opening portion K is about from 0.1 µm to 20 µm. As the width of each opening portion decreases, the number of the threading dislocations propagating from each opening portion to the first semiconductor layer S1 decreases. The widths (sizes in the X direction) of the low defect portions B2 and B3 can be increased.

The silicon oxide film may be decomposed and evaporated in a small amount during formation of the ELO semiconductor layer and taken into the ELO semiconductor layer, but the silicon nitride film and the silicon oxynitride film have an advantage of being hardly decomposed and evaporated at a high temperature.

Therefore, the mask layer 6 may be a single-layer film of a silicon nitride film or a silicon oxynitride film, may be a layered film in which a silicon oxide film and a silicon nitride film are formed in this order on the base layer 4, may be a layered body film in which a silicon nitride film and a silicon oxide film are formed in this order on the base layer 4, or may be a layered film in which a silicon nitride film, a silicon oxide film, and a silicon nitride film are formed in this order on the base layer.

When the first semiconductor layer S1 or the base semiconductor part 8 is formed using the ELO method, a template substrate including the base substrate UK and a mask pattern on the base substrate LTK may be used. The template substrate may include a growth suppression region (e.g., a region in which crystal growth in the Z direction is suppressed) corresponding to the mask portion 5 and a seed region corresponding to the opening portion K. For example, the growth suppression region and the seed region may be formed on the base substrate UK, and the first semiconductor layer S 1 or the base semiconductor part 8 may be formed on the growth suppression region and the seed region using the ELO method.

### (Compound Semiconductor Part and the like)

The compound semiconductor part 9 can be formed using, for example, an MOCVD device. For example, an n-type GaN layer can be used for the first contact layer 9A, an n-type AlGaN layer can be used for the first clad layer 9B, an n-type GaN layer can be used for the first light guide layer 9C, and a multi-quantum well (MQW) structure including an InGaN layer can be used for the active layer 9K. For example, a p-type AlGaN layer can be used for the electron blocking layer 9E, a p-type GaN layer can be used for the second light guide layer 9D, a p-type AlGaN layer can be used for the second clad layer 9F, and a p-type GaN layer can be used for the second contact layer 9G. Note that in the compound semiconductor part 9, the second light guide layer 9D and the electron blocking layer 9E may be switched and disposed in the p-type semiconductor layer 9P. For example, the p-type semiconductor layer 9P may be formed by forming the electron blocking layer 9E, the second light guide layer 9D, the second clad layer 9F, and the second contact layer 9G in this order.

The thickness of each layer of the semiconductor laser body 21 can be set as follows: the base semiconductor part 8 > the first clad layer 9B > the first light guide layer 9C > the active layer 9K, and the base semiconductor part 8 > the second clad layer 9F > the second light guide layer 9D > the active layer 9K. The refractive index of each layer of the compound semiconductor part 9 (refractive index of light generated in the active layer 9K) can be set as follows: the first clad layer 9B < the first light guide layer 9C < the active layer 9K, and the insulating film DF < the second clad layer 9F < the second light guide layer 9D < the active layer 9K.

For the first and second electrodes E1 and E2 and the first and second pad portions P1 and P2, for example, a single-layer film or a multilayer film including at least one of a metal film (an alloy film may also be used) containing at least one selected from the group consisting of Ni, Rh, Pd, Cr, Au, W, Pt, Ti, and Al and a conductive oxide film containing at least one selected from the group consisting of Zn, In, and Sn can be used. As the insulating film DF covering the ridge portion RJ, a single-layer film or a layered film containing an oxide or nitride of, for example, Si, Al, Zr, Ti, Nb, or Ta can be used.

The first semiconductor layer S 1 (ELO semiconductor layer), which serves as a base of the base semiconductor part 8, and the second semiconductor layer S2, which serves as a base of the compound semiconductor part 9, can be successively formed with a same film formation device (e.g., an MOCVD device). An intermediate substrate in a state where the first semiconductor layer S 1 is formed can be taken out once from the film formation device, and the second semiconductor layer S2 on the first semiconductor layer S 1 can be formed with another device. In this case, the second semiconductor layer S2 may be formed after an n-type GaN layer (e.g., the thickness of about 0.1 µm to about 3 µm) serving as a buffer at the time of regrowth is formed on the first semiconductor layer S1.

Examples of the material of the reflection boundary film UF covering the resonant end surfaces F1 and F2 include dielectrics such as SiO₂, Al₂O₃, AlN, AlON, Nb₂O₅, Ta₂O₅, and ZrO₂. The reflection boundary film UF may be a multilayer film. The reflection boundary film UF can be formed by electron beam evaporation, electron cyclotron resonance sputtering, chemical vapor deposition, or the like.

### Variation

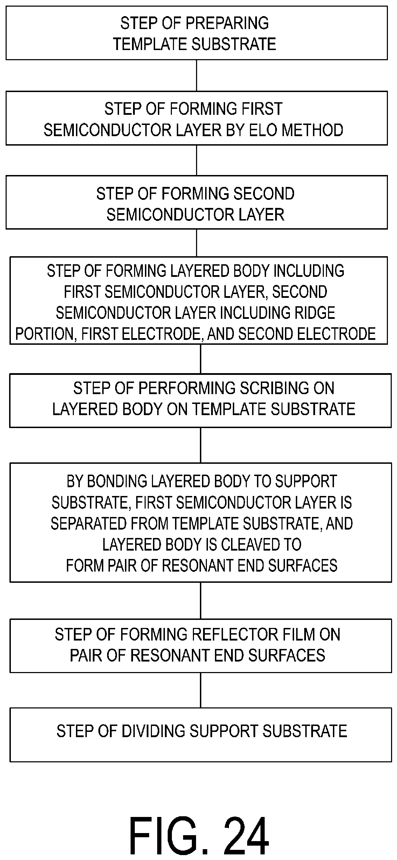

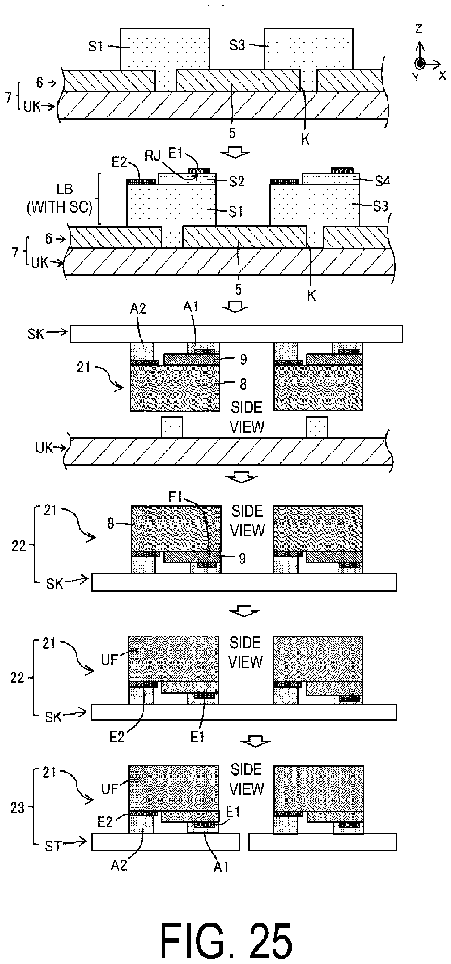

FIG. 24 is a flowchart showing another example of the manufacturing method of the semiconductor laser device according to Example 1. FIG. 25 is a schematic diagram illustrating the manufacturing method of the semiconductor laser device in FIG. 24. In the manufacturing method illustrated in FIGs. 24 and 25, after a step of scribing the layered body LB on the template substrate 7 (e.g., forming a starting point crack SC of m-plane cleavage), the layered body LB is bonded to the support substrate SK. Due to this, the first semiconductor layer S1 is separated from the template substrate 7, and cleavage of the layered body LB is performed to form the pair of resonant end surfaces F1 and F2.

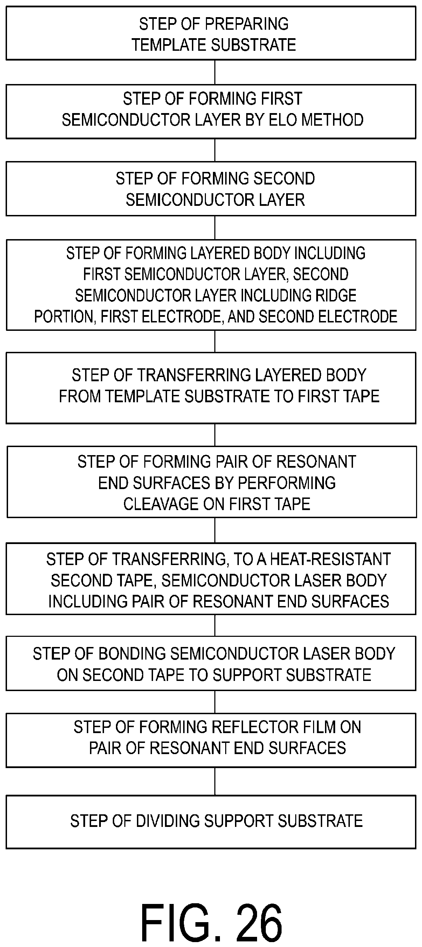

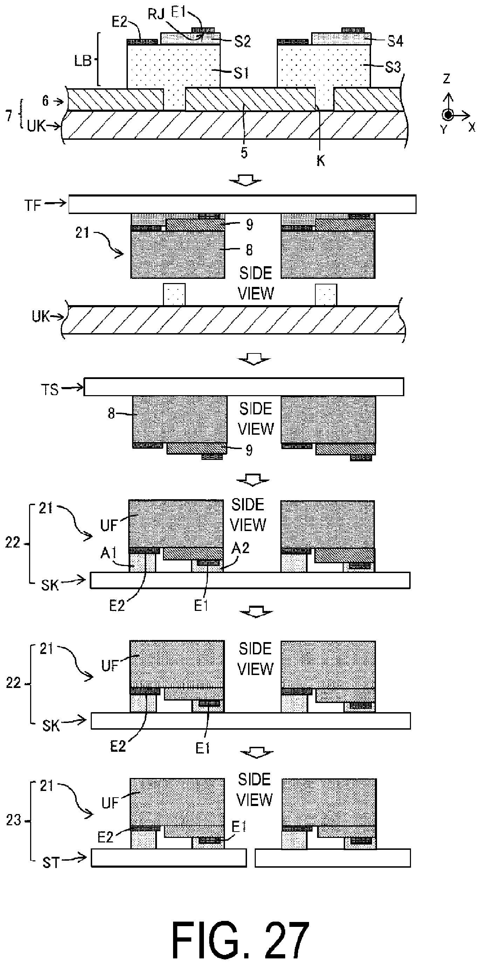

FIG. 26 is a flowchart showing another example of the manufacturing method of the semiconductor laser device according to Example 1. FIG. 27 is a schematic diagram illustrating the manufacturing method of the semiconductor laser device in FIG. 26. The manufacturing method illustrated in FIGs. 26 and 27 includes a step of transferring the layered body LB from the template substrate 7 to an adhesive first tape TF, a step of forming the pair of resonant end surfaces by performing cleavage of the layered body LB on the first tape TF, a step of transferring the semiconductor laser body 21 including the pair of resonant end surfaces F1 and F2 to a heat-resistant second tape TS, a step of bonding the semiconductor laser body 21 on the second tape TS to the support substrate SK, a step of forming the reflector film UF on the pair of resonant end surfaces F1 and F2, and a step of dividing the support substrate SK.

After the formation of the layered body LB, the mask layer 6 is removed by etching, and the layered body LB is transferred to the adhesive first tape TF, whereby the first semiconductor layer S1 is separated from the template substrate 7. Thereafter, by performing cleavage (m-plane cleavage) of the layered body LB on the first tape TF, the pair of resonant end surfaces F1 and F2 are formed. The resonant length (resonator length) can be equal to or less than 200 µm, but is not limited to this (the resonant length may be equal to or greater than 200 µm). After scribing (formation of a starting point of m-plane cleavage) is performed on the layered body LB, cleavage of the layered body LB may be performed to form the pair of resonant end surfaces F1 and F2. By scribing the layered body LB to release the internal stress, cleavage may be caused to naturally proceed. Next, the semiconductor laser body 21 is transferred to the second tape TS once, and the semiconductor laser body 21 on the second tape TS is bonded to the support substrate SK. Due to this, the two-dimensional arrangement semiconductor laser substrate (see FIG. 17) is formed. Next, the two-dimensional arrangement semiconductor laser substrate is divided for each row to form the one-dimensional arrangement (rod-like) semiconductor laser substrate 22 (see FIG. 18). Next, the reflector film UF is formed on the resonant end surfaces F 1 and F2 of the one-dimensional arrangement semiconductor laser substrate 22. Thereafter, the support substrate SK is divided into the plurality of support bodies ST, and each of the support bodies ST is caused to hold one or more semiconductor laser bodies 21, thereby forming the plurality of semiconductor laser elements 23 (see FIGs. 13 to 15). Each of the semiconductor laser bodies 21 is held by the support body ST in a junction-down manner (mounting form in which the ridge portion is positioned on the support body ST side).

As a base member of the first tape TF, a material such as polyethylene terephthalate (PET) can be used. As a base member of the second tape TS, a material such as polyimide can be used. The base members of the first and second tapes TF and TS may be made of the same material or may be made of different materials.

In FIG. 26, cleavage of the layered body LB is performed on the first tape TF, but the present invention is not limited to this. The cleavage of the layered body LB may be performed at the time of transfer from the template substrate 7 to the first tape TF. In this case, scribing can be performed on the layered body LB on the template substrate 7.

In FIG. 26, cleavage of the layered body LB is performed on the first tape TF, but the present invention is not limited to this. The layered body LB transferred onto the first tape TF may be transferred to a third tape, and cleavage may be performed on the third tape. For example, cleavage of the layered body LB may be performed by performing scribing or the like on a surface of the layered body LB positioned on a side opposite to a contact surface with the third tape, and applying stress to the layered body LB from a back surface of the third tape (through the third tape) using a blade for breaking, or the like. The third tape may be a dicing tape.

In this case, the base member of the first tape TF may be made of a material having a Young's modulus larger than that of the third tape. In this manner, deformation of the first tape TF when the first tape TF is pressed against the layered body LB can be reduced, and positional deviation of the layered body LB can be suppressed. On the other hand, since the third tape is more flexible than the first tape TF, for example, when stress is applied to the layered body LB in a breaking step or the like, the third tape easily follows the shape of the blade for breaking, and stress can be applied to a more concentrated range, whereby cleavage of the layered body LB is made easy.

In this case, the semiconductor laser body obtained by cleavage on the third tape may be transferred to the support substrate SK after being transferred to the (heat-resistant) second tape TS. The semiconductor laser body obtained by cleavage on the third tape may be transferred to a fourth tape once, further transferred to the (heat-resistant) second tape TS, and then transferred (bonded) to the support substrate SK (junction-down mounting is possible). The base member of the first tape TF can be made of, for example, PET, and the base member of the third tape can be made of, for example, polyolefin. The Young's modulus of the first tape TF may be, for example, equal to or greater than 2000 MPa, and the Young's modulus of the third tape may be, for example, equal to or less than 1500 MPa.

In the transfer of the layered body LB to the third tape, the transfer can be performed such that the upper surface of the layered body LB is exposed. For example, when the first semiconductor layer S1 is grown such that the upper surface (growth plane) of the first semiconductor layer S1 becomes the c-plane, which is the (0001) plane, the upper surface of the layered body LB also becomes the c-plane (Ga plane), and the cleavage can be easily performed by performing scribing for cleavage on the Ga plane.

The thickness of the layered body LB excluding the electrodes (the thickness of the semiconductor layer in the layered body) may be, for example, equal to or greater than 10 µm. As a result, the layered body LB to be cleaved can be prevented from being bowed without being split, and the yield is improved.

In FIG. 27, the semiconductor laser body on the first tape TF is transferred to the second tape TS and then bonded to the support substrate SK, but the present invention is not limited to this. The semiconductor laser body on the first tape TF may be transferred (bonded) to the support substrate SK and connected to a wiring line on the support substrate SK via, for example, a bonding wire. The semiconductor laser body obtained by cleavage of the layered body LB transferred to the third tape (from the first tape TF) can also be transferred (bonded) to the support substrate SK (from the third tape) (junction-down mounting is possible).

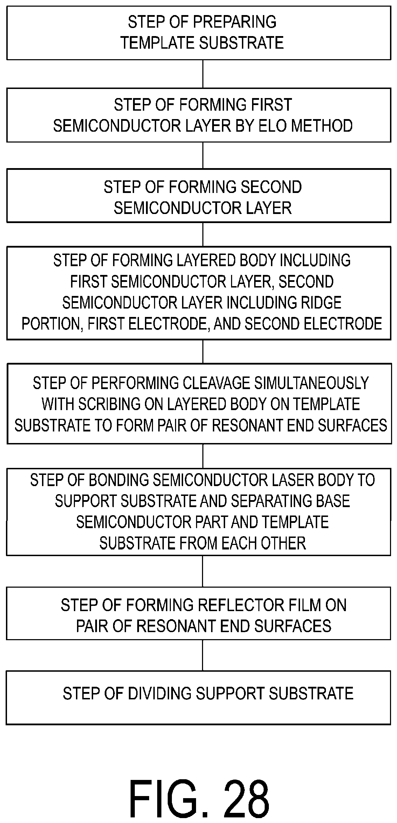

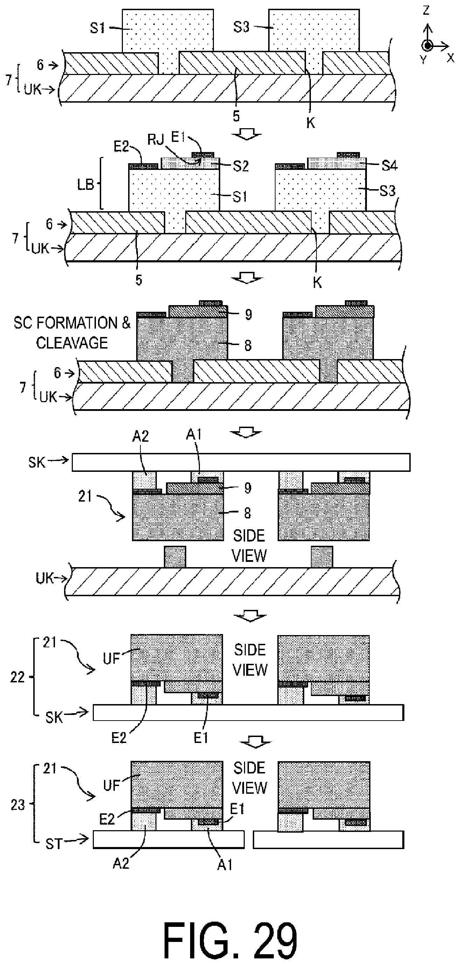

FIG. 28 is a flowchart showing another example of the manufacturing method of the semiconductor laser device according to Example 1. FIG. 29 is a schematic diagram illustrating the manufacturing method of the semiconductor laser device in FIG. 28. In the manufacturing method illustrated in FIGs. 28 and 29, a step of forming the pair of resonant end surfaces F1 and F2 by cleaving the layered body LB simultaneously with performing scribing on the layered body LB on the template substrate 7 (e.g., formation of the starting point crack SC of m-plane cleavage). In this step, cleavage naturally proceeds by releasing the internal stress of the layered body LB by scribing. The resonant length (resonator length) can be equal to or less than 200 µm, but is not limited to this, and may be equal to or greater than 200 µm. Thereafter, a step of separating the base semiconductor part 8 from the template substrate 7 is performed by bonding the semiconductor laser body 21 to the support substrate SK.

### Example 2

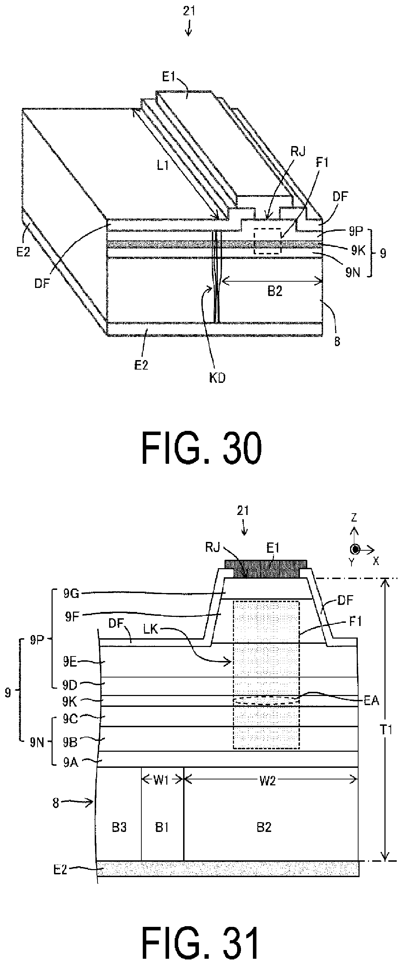

FIG. 30 is a perspective view illustrating the configuration of the semiconductor laser body according to Example 2. FIG. 31 is a cross-sectional view illustrating the configuration of the semiconductor laser body according to Example 2. In Example 1, the second electrode E2 is provided on the same side as the first electrode E1 with respect to the base semiconductor part 8, but the present invention is not limited to this. As illustrated in FIGs. 30 and 31, the second electrode E2 may be provided on a different side from the first electrode E1 with respect to the base semiconductor part 8 (i.e., the back surface of the base semiconductor part 8). The configurations of the base semiconductor part 8, the compound semiconductor part 9, and the first electrode E1 are the same as those in Example 1. In this manner, since the current path between the first and second electrodes E1 and E2 is shortened, the light emission efficiency in the active layer 9K can be enhanced.

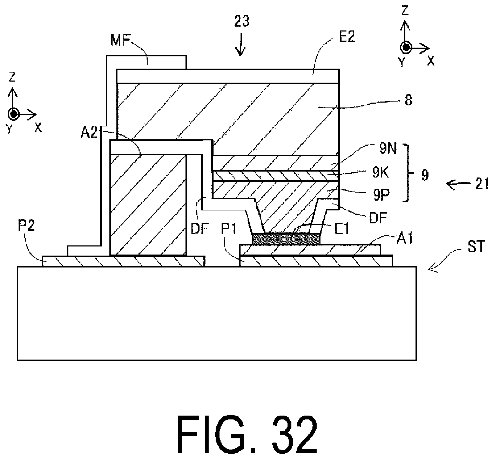

FIG. 32 is a cross-sectional view illustrating the configuration of a semiconductor laser element according to Example 2. The semiconductor laser element 23 includes the semiconductor laser body 21 including the base semiconductor part 8 and the compound semiconductor part 9, the support body ST holding the semiconductor laser body 21, and a conductive film MF in contact with the second electrode E2. The second electrode E2 is positioned on the back surface of the base semiconductor part 8, and the compound semiconductor part 9 and the first electrode E1 are closer to the support body ST than the base semiconductor part 8 is (junction-down manner).

The support body ST (e.g., a submount) includes the first and second pad portions P1 and P2 that are conductive and the first and second bonding portions A1 and A2 that are conductive. The first electrode E1 is connected to the first pad portion P1 via the first bonding portion A1, and the second electrode E2 is connected to the second pad portion P2 via the conductive film MF and the second bonding portion A2.

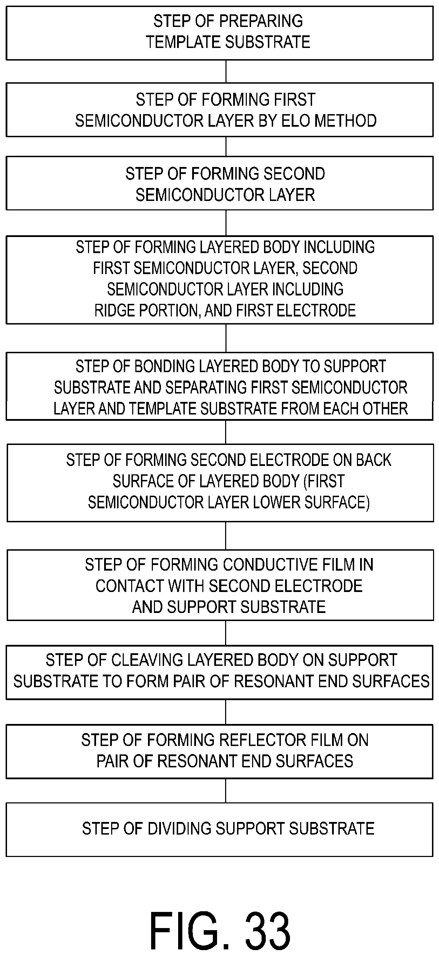

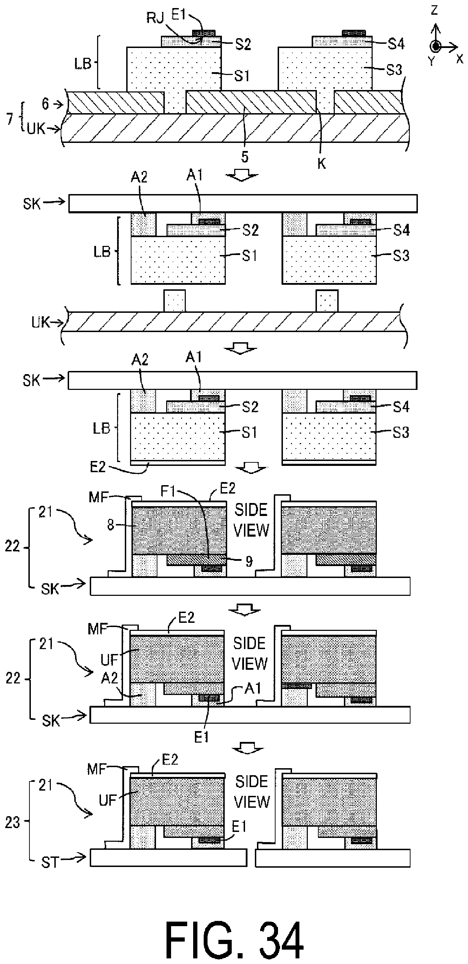

FIG. 33 is a flowchart showing another example of the manufacturing method of the semiconductor laser device according to Example 2. FIG. 34 is a schematic diagram illustrating the manufacturing method of the semiconductor laser device in FIG. 33. The manufacturing method illustrated in FIGs. 33 and 34 includes a step of preparing the template substrate 7 including the base substrate UK and the mask layer 6, a step of forming the first semiconductor layer S1 (and the third semiconductor layer S3), which serves as a base of the base semiconductor part 8, by the ELO method, a step of forming the second semiconductor layer S2 (and the fourth semiconductor layer S4), which serves as a base of the compound semiconductor part 9, a step of forming the layered body LB including the first semiconductor layer S1, the second semiconductor layer S2 including the ridge portion, and the first electrode E1 and the second electrode E2, a step of bonding the layered body LB to the support substrate SK and separating the first semiconductor layer S1 and the template substrate 7 from each other, a step of forming the second electrode E2 on the back surface of the layered body LB (the lower surface of the first semiconductor layer S1), a step of forming the conductive film MF in contact with the second electrode E2 and (the second pad portion P2 of) the support substrate SK, a step of performing cleavage of the layered body LB on the support substrate SK (m-plane cleavage of the nitride semiconductor layer) and forming (the optical resonator LK including) the pair of resonant end surfaces F 1 and F2, a step of forming the reflector film UF on each of the pair of resonant end surfaces F1 and F2, and a step of dividing the support substrate SK into a plurality of the support bodies ST.

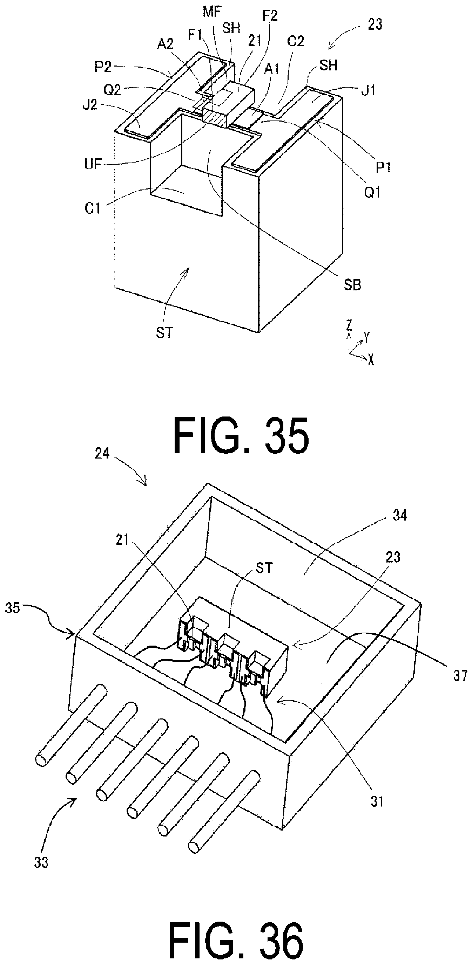

FIG. 35 is a perspective view illustrating the configuration of the semiconductor laser element according to Example 2. As illustrated in FIG. 35, the semiconductor laser element 23 includes the semiconductor laser body 21 and the support body ST. The support body ST includes two wide portions SH having a width larger than the resonant length of the semiconductor laser body 21, and a placement portion SB positioned between the two wide portions SH and having a width smaller than the resonant length.

The support body ST includes the first pad portion P1 and the second pad portion P2 having T shapes. The first pad portion P1 includes the mounting portion J1 positioned on the wide portion SH and having a length in the Y direction larger than the resonant length L1, and the contact portion Q1 positioned on the placement portion SB and having a length in the Y direction smaller than the resonant length L1, and the second pad portion P2 includes the mounting portion J2 positioned on the wide portion SH and having a length in the Y direction larger than the resonant length L1, and the contact portion Q2 positioned on the placement portion SB and having a length in the Y direction smaller than the resonant length L1. The contact portions Q1 and Q2 are arranged in the X direction on the upper surface of the placement portion SB, and the second bonding portion A2 is formed on the contact portion Q2. The first bonding portion A1 is in contact with the first electrode E1 (anode) of the semiconductor laser body 21. The contact portion Q2 of the second pad portion P2 is in contact with the conductive film MF of the semiconductor laser body 21, whereby the second electrode E2 (cathode) and the second pad portion P2 are electrically connected.

### Example 3

In Examples 1 and 2, the first semiconductor layer S1 (ELO semiconductor layer), which serves as a base of the base semiconductor part 8, can be a GaN layer, but an InGaN layer, which is a GaN-based semiconductor layer, can also be formed as the ELO semiconductor layer. The lateral film formation of the InGaN layer is performed at a low temperature below 1000°C, for example. This is because the vapor pressure of indium increases at a high temperature and indium is not effectively taken into the film. When the film formation temperature is low, an effect is exhibited in which the interaction between the mask portion 5 and the InGaN layer is reduced. The InGaN layer has an effect of exhibiting lower reactivity with the mask portion 5 than the GaN layer. When indium is taken into the InGaN layer at an In composition level of 1% or more, the reactivity with the mask portion 5 is further lowered, which is desirable. As the gallium raw material gas, triethylgallium (TEG) is preferably used.

### Example 4

FIG. 36 is a perspective view illustrating the configuration of a semiconductor laser module of Example 4. A semiconductor laser module 24 (semiconductor laser device) in FIG. 36 is a surface mounting package, and includes a housing 35 and the semiconductor laser element 23 (see, for example, FIG. 15). The semiconductor laser element 23 includes the plurality of semiconductor laser bodies 21, and is provided such that a side surface (a surface parallel to the resonant end surface) of the support body ST faces a bottom surface 37 of the housing 35. Therefore, the emission face (the resonant end surface F1 on the emission side) of each of the semiconductor laser bodies 21 faces a top surface 34 (transparent plate) of the housing 35, and laser light is emitted from the top surface 34 of the housing 35. The semiconductor laser element 23 is connected to an external connection pin 33 via a wire 31.

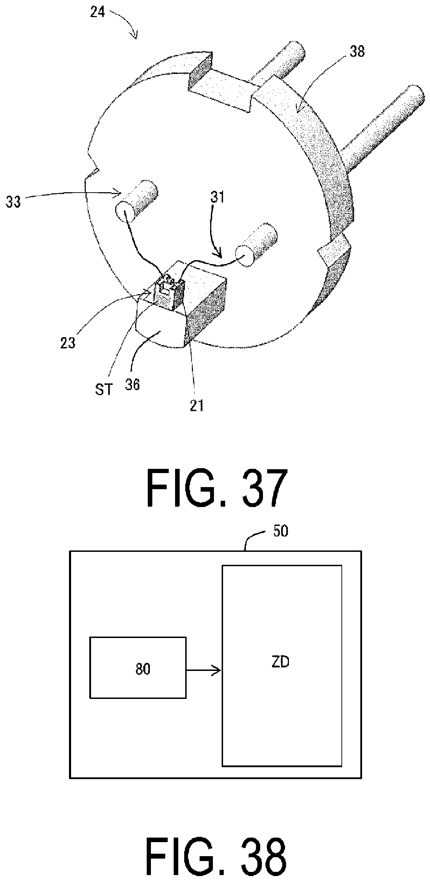

FIG. 37 is a perspective view illustrating another configuration of the semiconductor laser module of Example 4. The semiconductor laser module 24 (semiconductor laser device) in FIG. 37 is a TO-CAN mounting package, and includes a stem 38 and the semiconductor laser element 23 (see, for example, FIG. 13). The semiconductor laser element 23 is disposed on a heat block 36 protruding from a base of the stem 38. The first and second pad portions P1 and P2 of the semiconductor laser element 23 are connected to the external connection pin 33 via the wire 31.

In the known technique, the semiconductor laser chips need to be individually die-bonded to a submount to produce a chip on submount (CoS). However, in Examples 1 to 4, since the support body ST of the semiconductor laser element 23 functions as a submount and the semiconductor laser element 23 itself has a CoS structure, die-bonding to the submount is unnecessary. This can solve the problem of difficulty in handling when the resonant length (resonator length) is short or the chip width (size in the X direction) is narrow. Specifically, the semiconductor laser element 23 includes the first and second pad portions P1 and P2 that satisfy the size condition required for striking a wire bond on the support body ST. The first and second pad portions P1 and P2 are electrically connected to the first and second electrodes (anode and cathode) of the semiconductor laser body 21 (semiconductor laser chip). Therefore, electrically connecting the external connection pin 33 of the package and the first and second pad portions P1 and P2 with the wire 31 is sufficient.

### Example 5

FIG. 38 is a schematic diagram illustrating the configuration of the electronic apparatus according to Example 5. An electronic apparatus 50 in FIG. 38 includes a semiconductor laser device ZD (21 to 24) according to Examples 1 to 4, and a controller 80 that includes a processor and controls the semiconductor laser device ZD. Examples of the electronic apparatus 50 include lighting devices, display devices, communication devices, information processing devices, medical apparatuses, and electric vehicles (EV).

### Example 6

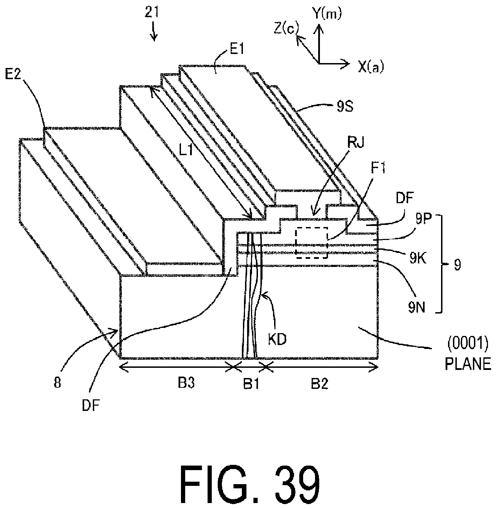

In Example 1, the compound semiconductor part 9 is provided on the c-plane of the base semiconductor part 8, and the pair of resonant end surfaces are each the m-plane of the nitride semiconductor, but the present invention is not limited to this. As illustrated in FIG. 39, the compound semiconductor part 9 can be provided on the m-plane ((1-100) plane) of the base semiconductor part 8 and the pair of resonant end surfaces can each be the c-plane ((0001) plane) of the nitride semiconductor. The resonant length L1 is a length in the c-axis direction. The resonant end surface F 1 can be formed by c-plane cleavage of the nitride semiconductor, for example.

The above-described technical forms are for illustrative and descriptive purposes and not for a restrictive purpose. It is apparent to those skilled in the art that many variations are possible based on these illustrations and descriptions.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

7 Template substrate
8 Base semiconductor part
9 Compound semiconductor part
21 Semiconductor laser body
22 Semiconductor laser substrate
23 Semiconductor laser element
24 Semiconductor laser module
S 1 First semiconductor layer
S2 Second semiconductor layer
LK Optical resonator
RJ Ridge portion
B 1 First portion
B2 Second portion (low dislocation portion)
B3 Third portion (low dislocation portion)
F1 and F2 Pair of resonant end surfaces
P1 First pad portion
P2 Second pad portion
E1 First electrode
E2 Second electrode
UF Reflector film
ST Support body
SB Placement portion
SK Support substrate

## Claims

1. A semiconductor laser body comprising:
a base semiconductor part; and
a compound semiconductor part positioned on the base semiconductor part and containing a GaN-based semiconductor,
wherein the base semiconductor part comprises a first portion and a second portion having a lower density of threading dislocation extending in a thickness direction than the first portion,
the compound semiconductor part comprises an optical resonator comprising a pair of resonant end surfaces,
at least one of the pair of resonant end surfaces is an m-plane or a c-plane of the compound semiconductor part, and
a resonant length, which is a distance between the pair of resonant end surfaces, is equal to or less than 200 [µm].

2. A semiconductor laser body comprising:
a base semiconductor part; and
a compound semiconductor part positioned on the base semiconductor part,
wherein the base semiconductor part comprises a first portion and a second portion having a lower density of threading dislocation extending in a thickness direction than the first portion,
the compound semiconductor part comprises an optical resonator comprising a pair of resonant end surfaces,
at least one of the pair of resonant end surfaces is comprised in a cleavage plane of the compound semiconductor part, and
a resonant length, which is a distance between the pair of resonant end surfaces, is equal to or less than 200 [µm].

3. A semiconductor laser body comprising:
a base semiconductor part; and
a compound semiconductor part positioned on the base semiconductor part,
wherein the base semiconductor part comprises a first portion and a second portion having a lower density of threading dislocation extending in a thickness direction than the first portion,
the compound semiconductor part comprises an optical resonator comprising a pair of resonant end surfaces,
at least one of the pair of resonant end surfaces has an optical reflectance of equal to or greater than 98%, and
a resonant length, which is a distance between the pair of resonant end surfaces, is equal to or less than 200 [µm].

4. The semiconductor laser body according to any one of claims 1 to 3, wherein a sum of a thickness of the base semiconductor part and a thickness of the compound semiconductor part is equal to or less than 50 [µm].

5. The semiconductor laser body according to any one of claims 1 to 4, wherein the base semiconductor part is a self-supported layer with no support member.

6. The semiconductor laser body according to any one of claims 1 to 5, further comprising a reflector film covering at least one surface of the pair of resonant end surfaces.

7. The semiconductor laser body according to any one of claims 1 to 6, wherein
one of the pair of resonant end surfaces comprises a light emission region, and
the light emission region overlaps the second portion in plan view viewed in the thickness direction.

8. The semiconductor laser body according to any one of claims 1 to 7, wherein
the base semiconductor part comprises a base end surface parallel to the pair of resonant end surfaces, and
a dislocation density of the base end surface is equal to or higher than the density of threading dislocation of the second portion.

9. The semiconductor laser body according to any one of claims 1 to 7, wherein a ratio of the resonant length to a thickness of the second portion is 1 to 20.

10. The semiconductor laser body according to any one of claims 1 to 9, wherein
a size of the second portion in a direction orthogonal to a direction defining the resonant length is a width of the second portion, and
a ratio of the resonant length to the width of the second portion is 1 to 10.

11. The semiconductor laser body according to any one of claims 1 to 10, wherein
a size of the first portion in a direction orthogonal to a direction defining the resonant length is a width of the first portion, and
a ratio of the resonant length to a width of the first portion is 1 to 200.

12. The semiconductor laser body according to any one of claims 1 to 11, wherein the density of threading dislocation of the second portion is equal to or lower than 1/5 of the density of threading dislocation of the first portion.

13. The semiconductor laser body according to any one of claims 1 to 12, wherein
the base semiconductor part comprises a third portion having a lower density of threading dislocation extending in a thickness direction than the first portion, and
the first portion is positioned between the second portion and the third portion.

14. The semiconductor laser body according to any one of claims 1 to 13, wherein the compound semiconductor part comprises an n-type semiconductor layer, an active layer, and a p-type semiconductor layer.

15. The semiconductor laser body according to claim 14, wherein the optical resonator comprises at least a part of the n-type semiconductor layer, at least a part of the active layer, and at least a part of the p-type semiconductor layer.

16. The semiconductor laser body according to claim 15, wherein
the compound semiconductor part comprises a ridge portion, and
the ridge portion overlaps the second portion in plan view viewed in the thickness direction.

17. The semiconductor laser body according to claim 16, wherein the ridge portion does not overlap the first portion in plan view.

18. The semiconductor laser body according to claim 16 or 17, wherein
the n-type semiconductor layer comprises a first clad layer,
the p-type semiconductor layer comprises a second clad layer, and
at least a part of the second clad layer is comprised in the ridge portion.

19. The semiconductor laser body according to claim 18, wherein
the n-type semiconductor layer comprises a first light guide layer closer to the active layer than the first clad layer is, and
the p-type semiconductor layer comprises a second light guide layer closer to the active layer than the second clad layer is.

20. The semiconductor laser body according to claim 18, further comprising:
an insulating film covering a side surface of the ridge portion,
wherein a refractive index of the insulating film is lower than a refractive index of the second clad layer.

21. The semiconductor laser body according to any one of claims 1 to 20, wherein a scribe trace is present on at least one of the pair of resonant end surfaces.

22. The semiconductor laser body according to any one of claims 1 to 21, further comprising a first electrode overlapping the optical resonator in plan view viewed in the thickness direction.

23. The semiconductor laser body according to claim 22, wherein the first electrode overlaps the second portion in plan view.

24. The semiconductor laser body according to claim 22 or 23, wherein the first electrode has a shape in which a direction defining the resonant length is a long direction, the first electrode having a size in the long direction smaller than the resonant length.

25. The semiconductor laser body according to any one of claims 22 to 24, further comprising a second electrode positioned on a same side as or a different side from the first electrode with respect to the base semiconductor part.

26. The semiconductor laser body according to claim 25, wherein
the base semiconductor part comprises a third portion having a lower density of threading dislocation extending in a thickness direction than the first portion, and
the second electrode overlaps the third portion in plan view.

27. The semiconductor laser body according to claim 25 or 26, wherein the first electrode is an anode, and the second electrode is a cathode.

28. The semiconductor laser body according to claim 2 or 3, wherein
the compound semiconductor part contains a GaN-based semiconductor, and
each of the pair of resonant end surfaces is an m-plane of the compound semiconductor part.

29. The semiconductor laser body according to claim 1 or 28, wherein surface roughness of at least one of the pair of resonant end surfaces is smaller than surface roughness of a side surface parallel to an a-plane of the compound semiconductor part.

30. The semiconductor laser body according to claim 27, wherein power of equal to or less than 200 [mW] is supplied between the first electrode and the second electrode.

31. The semiconductor laser body according to any one of claims 1 to 30, wherein the density of threading dislocation of the second portion is equal to or lower than 5 × 10⁶/cm².

32. The semiconductor laser body according to any one of claims 1 to 31, wherein the base semiconductor part contains a GaN-based semiconductor.

33. A semiconductor laser element comprising:
the semiconductor laser body according to any one of claims 1 to 32; and
a support body holding the semiconductor laser body.

34. The semiconductor laser element according to claim 33, wherein
the support body comprises a placement portion having a width smaller than the resonant length, and
the semiconductor laser body is positioned on the placement portion with a width direction of the placement portion coinciding with a direction defining the resonant length.

35. The semiconductor laser element according to claim 34, wherein at least one of the pair of resonant end surfaces protrudes from the placement portion in plan view viewed in the thickness direction.

36. The semiconductor laser element according to claim 35, wherein
the placement portion is formed between two notch portions facing each other in the direction defining the resonant length, and
the pair of resonant end surfaces are positioned above the two notch portions.

37. The semiconductor laser element according to any one of claims 34 to 36, wherein the support body comprises a first pad portion and a second pad portion whose sizes in the direction defining the resonant length are larger than the resonant length.

38. The semiconductor laser element according to claim 37, wherein the placement portion comprises a first bonding portion electrically connected to the first pad portion and a second bonding portion electrically connected to the second pad portion.

39. The semiconductor laser element according to claim 38, wherein the second bonding portion is greater in thickness than the first bonding portion.

40. The semiconductor laser element according to any one of claims 34 to 39, further comprising:
a reflector film covering at least one of the pair of resonant end surfaces; and
a dielectric film formed on a side surface of the placement portion and made of a same material as the reflector film.

41. A semiconductor laser substrate comprising:
a plurality of semiconductor laser bodies and a support substrate holding the plurality of semiconductor laser bodies,
wherein each of the semiconductor laser bodies is the semiconductor laser body according to any one of claims 1 to 32.

42. An electronic apparatus comprising:
the semiconductor laser body according to any one of claims 1 to 32.

43. A manufacturing method of a semiconductor laser device, comprising:
forming a first semiconductor layer having a band shape on a template substrate by an ELO method;
forming a second semiconductor layer on the first semiconductor layer; and
forming a pair of resonant end surfaces on the second semiconductor layer with a resonant length, which is a distance between the pair of resonant end surfaces, being equal to or less than 200 [µm].

44. The manufacturing method of a semiconductor laser device, according to claim 43, wherein at least one of the pair of resonant end surfaces is formed by cleavage of the second semiconductor layer.

45. The manufacturing method of a semiconductor laser device, according to claim 43 or 44, wherein
the second semiconductor layer contains a GaN-based semiconductor, and
the pair of resonant end surfaces are each an m-plane of the second semiconductor layer.

46. The manufacturing method of a semiconductor laser device, according to any one of claims 43 to 45, further comprising:
forming, on the template substrate, a third semiconductor layer of a same layer as the first semiconductor layer;
forming, on the third semiconductor layer, a fourth semiconductor layer of a same layer as the second semiconductor layer; and
forming a pair of resonant end surfaces on the fourth semiconductor layer.

47. The manufacturing method of a semiconductor laser device, according to any one of claims 43 to 46, wherein
the first semiconductor layer comprises a first portion and a second portion having a density of threading dislocation of equal to or lower than 1/5 of a density of threading dislocation of the first portion, and
a ridge portion overlapping the second portion in plan view is formed in the second semiconductor layer before the pair of resonant end surfaces are formed.

48. The manufacturing method of a semiconductor laser device, according to any one of claims 43 to 47, further comprising:
forming a first electrode; and
bonding a layered body comprising the first semiconductor layer, the second semiconductor layer, and the first electrode to a support substrate.

49. The manufacturing method of a semiconductor laser device, according to claim 48, further comprising separating the layered body from the template substrate.

50. The manufacturing method of a semiconductor laser device, according to claim 49, wherein
the pair of resonant end surfaces are formed on the second semiconductor layer comprised in the layered body on the support substrate.

51. The manufacturing method of a semiconductor laser device, according to claim 49, wherein
the pair of resonant end surfaces are formed when the layered body is bonded to the support substrate.

52. The manufacturing method of a semiconductor laser device, according to any one of claims 43 to 47, further comprising:
forming a first electrode;
transferring a layered body comprising the first semiconductor layer, the second semiconductor layer, and the first electrode from the template substrate to a first tape; and
forming at least one of the pair of resonant end surfaces on the first tape.

53. The manufacturing method of a semiconductor laser device, according to claim 52, wherein at least one of the pair of resonant end surfaces is formed by scribing the layered body on the first tape.

54. The manufacturing method of a semiconductor laser device, according to any one of claims 43 to 47, further comprising:
forming a first electrode;
transferring a layered body comprising the first semiconductor layer, the second semiconductor layer, and the first electrode from the template substrate to a first tape; and
forming at least one of the pair of resonant end surfaces when the layered body is transferred to the first tape.

55. The manufacturing method of a semiconductor laser device, according to any one of claims 52 to 54, wherein after a semiconductor laser body positioned on the first tape and comprising the pair of resonant end surfaces is transferred to a second tape, the semiconductor laser body positioned on the second tape is bonded to a support substrate.

56. The manufacturing method of a semiconductor laser device, according to any one of claims 50, 51, and 55, further comprising forming a reflector film on each of the pair of resonant end surfaces above the support substrate.

57. The manufacturing method of a semiconductor laser device, according to any one of claims 50, 51, and 55, wherein the support substrate is divided into a plurality of support bodies, and each of the support bodies is caused to hold one or more semiconductor laser bodies comprising the pair of resonant end surfaces.

58. The manufacturing method of a semiconductor laser device, according to claim 57, wherein
the one or more semiconductor laser bodies are held by the support body in a junction-down manner.

59. A manufacturing apparatus of a semiconductor laser device, wherein the manufacturing apparatus performs each of the steps according to claim 43.
